# EUROPEAN PATENT APPLICATION

(11) **EP 1 118 905 A2**
(43) Date of publication of application: **25.07.2001**
(21) Application number: 01200514.6
(22) Date of filing: 01.02.2000
(51) Int. Cl.: G03B 21/20, G03B 21/60, G03B 21/62, F21V 13/00

(54) **Projector and display using optical element for diffraction and scattering**

(30) Priority: 04.02.1999 JP 2757499; 16.03.1999 JP 6975199; 09.07.1999 JP 19559599; 05.10.1999 JP 28439299; 12.10.1999 JP 28957899
(62) Divisional of application: 00902041.3
(71) Applicant: Matsushita Electric Industrial Co., Ltd., Kadoma-shi, Osaka 571 (JP)
(72) Inventor: Kuratomi, Yasunori, Hyogo (JP); Ogiwara, Akifumi, 2-7-9 Osaka (JP)
(74) Representative: Dempster, Benjamin John Naftel

(57) **Abstract**

The present invention provides, at a reasonable price, a lighting device for lighting up an object to be illuminated at uniform and high efficiency for light utilization, and a device for displaying images excellent in hue, visual recognition observability, brightness and uniformity. The present invention also provides, at a reasonable price, an excellent image display device or the like using such a lighting device as a light source.

Therefore, a diffractive optics is particularly used for condensing a bundle of light from a lamp, deflecting an image light or the like. In particular, scattering anisotropy due to the incident angle and the wavelength, change in the diffraction efficiency, change in the transmission characteristic or the like is utilized.

Moreover, an optical element such as Fresnel lens is also used together with the diffractive optics.

## Description

### Technical Field

The present invention relates to a projector device, more particularly, to an image projector device, an image display device or a lighting device using a thin film optical element for diffraction and scattering.

### Background Technology

### [First, a general description of background technology is given.]

Together with the enhancement of technology in the art in recent years, a lighting device of which the brightness of the images in the central part as well as in the peripheral part of the display, or screen, is uniform and a projector device of which the light energy in the central part and in the peripheral part of the illuminated region is equal are in high demand and a variety of lighting devices which satisfy such requirements have been developed and proposed.

Next, together with the development of liquid crystal and laser as well as hologram, which was developed at the same time, a thin film optical element which utilizes diffraction and scattering to gain a variety of functions, operations and effects (or which utilizes the technologies with respect to those) has been widely adopted in image projector devices in recent years.

First, a lighting or a projector device of which the brightness in the central and peripheral parts of an object to be illuminated, or a scene of the display, is uniform is described.

A lighting device which illuminates an object brightly and uniformly plays an important role in a lighting optical system for a liquid crystal projector or a projection aligner used for the production of semiconductor devices such as ICs or LSIs.

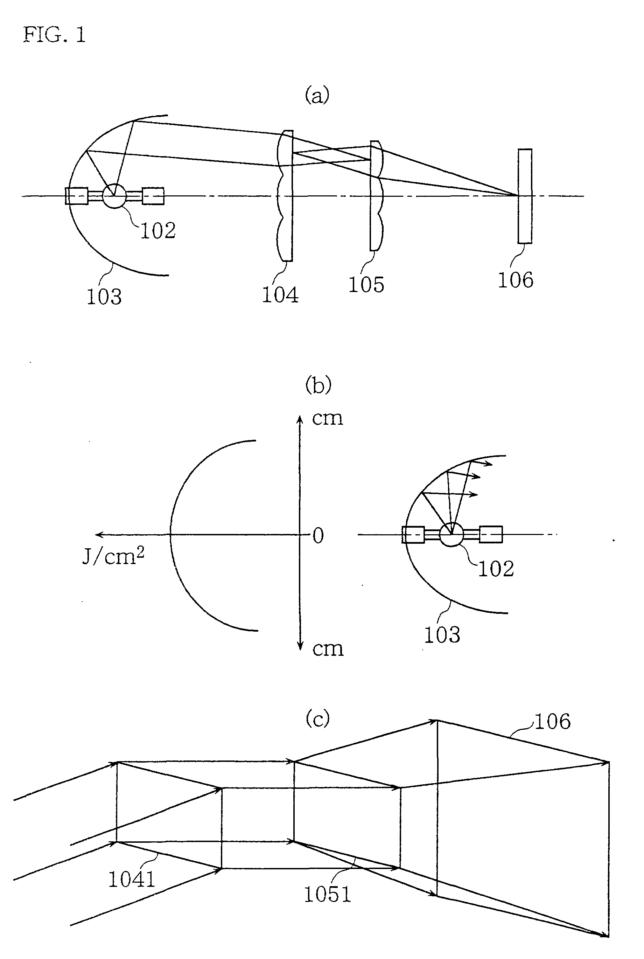

And a lighting device used therein illuminates an object with a light bundle from a light source via a relay optical system through a pair of lens arrays as shown, for example, in Fig. 1(a). That is to say, a light bundle from a lamp 102 is reflected by a reflector 103 and then enters into the first lens array 104. At this time, an image of the lamp (more precisely an illuminating object) 102 is formed on each of the microscopic lenses of the second lens array 105 which corresponds to each of the microscopic lenses of the first lens array 104 by means of the reflector 103 and the first lens array 104. In addition, each lens of the second lens array 105 forms an image formed by each lens making up the first lens array 104 on an object 106 to be illuminated.

In the above described configuration, an image formed on the object to be illuminated by each lens of the second lens array is gained as a result wherein an output light bundle having a wide luminance distribution which is outputted from the reflector is divided by each lens of the first lens array and the divided light bundle is overlapped on the object to be illuminated. Then, due to this principle, it becomes possible to make the brightness of the peripheral part 80 % or more in comparison with the central part of the object to be illuminated.

Here, the reason why lens array are used is that a reflected light from the reflector as shown in Fig. 1(b), being farther away from the light source, has a lower energy density when reflected from a position farther away from the central part or from a part corresponding to the light source, and the central part is in the shade of the light source because of the existence thereof and, therefore, the brightness or the energy density become uneven, between the central and peripheral parts of the object to be illuminated, which must be compensated.

Also the reason why two lens arrays are used is that it is difficult to sufficiently compensate with only one lens array because the periphery becomes out of focus.

In addition, for a further compensation, the microscopic lens 1041 forming the lens arrays 104 is, principally, a similar shape to the object 106 to be illuminated as shown in Fig. 1(c). That is to say, in the case that an object to be illuminated is, for example, an ordinal screen for image display, a ratio of height to width of 3 to 4 and, in the case of a screen for high vision, the ratio is 9 to 16.

The lens arrays have a size of approximately 5.6 centimeters square, the microscopic lenses have a size of approximately 5.6 millimeters square and the focal distance is approximately 50 to 60 mm, though they depend on applications or the like.

Here, those matters are in a category of technologies well known in the art and therefore, further description is omitted.

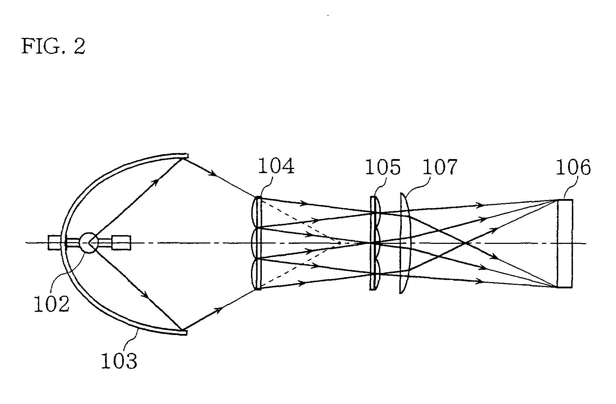

In the case of use for a lighting optical system of a liquid crystal projector the light utilization efficiency can also be improved by an integrator. Here, in this case, a condenser lens 107 for condensing light, a dichroic mirror for breaking up the color, a relay lens and an auxiliary lens (none of them are shown in the figure) are arranged, if necessary, between the second lens array 105 and the object 106 to be illuminated (image display element such as a liquid crystal panel) as shown in Fig. 2, which do not change the essential function as an integrator.

Though, generally, a light bundle reflected by a reflector is in a substantially circular form, an object to be illuminated (in this case a liquid crystal panel, which is denoted as 106 in Fig. 1) is in a rectangular form of a ratio of, for example, 4 to 3 or 16 to 9. Therefore, in the case that they are used alone for illuminating the object, only the area of the rectangular form inscribed in the circular light bundle can be effectively utilized. This is referred to as rectangular conversion efficiency. And, for example, in the case of an object in the above described rectangular shape of a ratio of 4 to 3, the rectangular conversion efficiency is approximately 61 % and, in order to improve this, the opening shape of the lens used for the first lens array of the integrator is made to be a similar shape to the object to be illuminated, which is in a ratio of 4 to 3 and, in addition, each of the microscopic lenses in the effective region illuminated in a circular shape by the first lens array is formed in high density, which increases to approximately 80 %, as disclosed in Fig. 2 of Japanese Unexamined Patent Application Publication No. Hei 5-346557.

A light bundle (light ray) from the light source which can effectively illuminate the object to be illuminated is solely the light bundle which has been once reflected by the reflection mirror and has entered the first lens array when utilized alone. This is because the light bundle which has entered the microscopic lens forming the first lens array directly from the light source, or the light bundle moving toward the opening part, cannot enter the corresponding microscopic lens in the second lens array which does not contribute to the illumination of the object.

Here, a value resulting from dividing a solid angle covered by the reflection mirror having the illuminating body of the light source as the center by 4π is defined as a mirror solid angle rate. This represents a ratio between a light bundle reflected by the reflection mirror and the entire light bundle from the light source in the case that the light source is assumed to emit light equally in all directions. And the mirror solid angle rate in this lighting optical system is approximately 70 %.

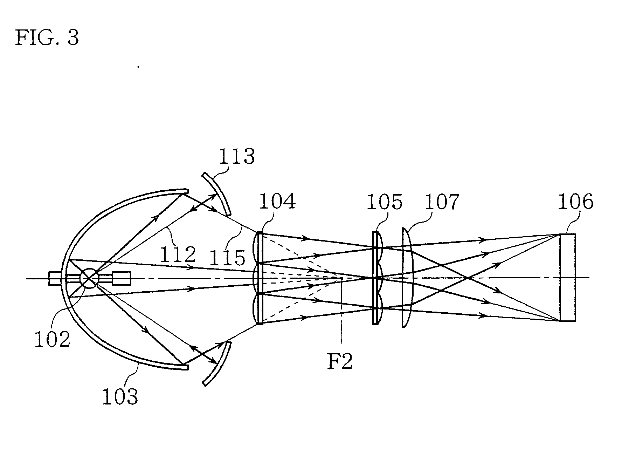

Therefore, as disclosed for example in IEEE Transactions on Consumer Electronics, Vol. 43, No. 3 AUGUST (1997) pp. 801-806, an attempt is made to enhance the mirror solid angle rate by using two types of reflection mirrors. This principle is described in reference to Fig. 3.

In the figure, a light source 102 is covered by an ellipsoidal mirror 103 which is a conventionally existing reflector, and a spherical mirror 113 for improving the mirror solid angle rate, and the focal point of the ellipsoidal mirror and the center of the spherical mirror are substantially aligned with the position of the illuminating body of the light source. And, thereby, a light bundle which has conventionally deviated from the opening part of the ellipsoidal mirror is reflected to the light source by the spherical mirror so as to be released to the environment again from the light source.

Next, an image projector device using a thin film optical element is described.

Together with the development of a holographic screen in recent years a number of devices for projecting an image onto a holographic screen which also works in a show window or other windows to draw attention at a showroom, exhibition or a store have been developed (Japanese Unexamined Patent Application Publication No. Hei 5-88020, Japanese Unexamined Patent Application Publication No. Hei 9-33856 or the like). All of these disclose that a hologram is attached to the glass of, for example, a show window or other windows as a substrate so as to form a holographic screen, onto which an image (light) is projected, for example diagonally, so as to display an image by diffracting this image (light) in the direction of the viewer. In this case, the angle dependence of the diffraction efficiency particular to the hologram, that is to say, a phenomenon, wherein a light bundle deviated considerably from a predetermined angle enters a hologram reducing the diffraction efficiency, is utilized so that the viewer can see an exhibit on the opposite side of the glass in the case of not projecting an image and, therefore, it becomes useful as an advertising media to draw attention not in a dark room but, rather, along a relatively bright street or the like.

A light control film having a scattering anisotropy is also used instead of a holographic screen. Here, the light control film having a scattering anisotropy (greatly) scatters light entering from an angle in a particular range (more precisely scatters light (forms an image) so that a person can recognize a projected image clearly and allows the image forming light to be transmitted to the opposite side, to the light entering side (completely transparent film, or a substantially transparent film, allows light to pass through as it is so that the projected image cannot be seen by a person while that containing a white wall will not allow light to transmit through to reach the backside so that the projected image cannot be seen by a person from the other side). Here, a precise description in detail in order to avoid misunderstanding becomes too complicated and, therefore, it is simply described as "scattering.") and allows light entering from other angles to be transmitted (almost as it is).

Here, the principle and the characteristics of holography are well known in the art as described in, for example, "interference and coherency (particularly pp. 97-105)" by Yoshio Kainuma, published by Kyoritsu Shuppan, "Introduction to Holography" by Toshihiro Kubota or the like. Therefore, the description of those is omitted.

In the case of the use of this light control film, positions from which the images viewed most brightly are along the extending line connecting the projector-type image display means formed by, for example, a liquid crystal projector (here, in the case that screen is a white cloth it has the same effects as that in an ordinary projector-type image display means) and the screen. That is to say, in the case that an image is projected diagonally from below, the configuration makes the viewer look into the screen from diagonally above. Here, in an image display device using such a conventional holographic screen scattering light or the like is used as object light in order to broaden the viewing range (range of the angle the viewer can see the image brightly and clearly) (Japanese Unexamined Patent Application Publication No. Hei 8-202248).

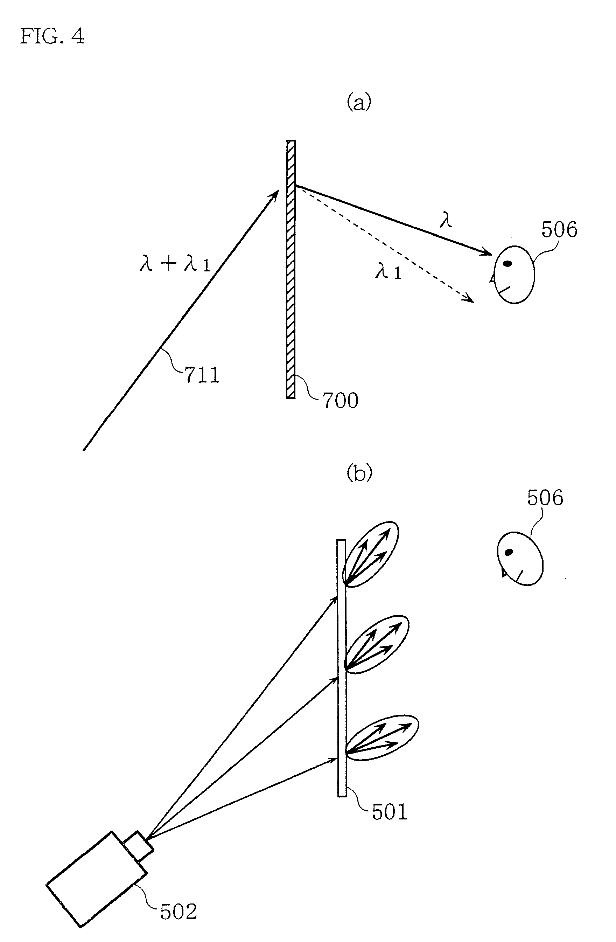

In this case, due to the wavelength dependence inherent to holograms, the diffraction efficiency becomes the highest for the wavelength used to expose the inherent rings (hereinafter referred to as "main wavelength" in abbreviated form) and the diffraction efficiency is lowered in relation to the amount of shift. In addition, as a result of the scattered angle being different due to the incident wavelength, white color cannot be prevented from being displayed with a certain degree of color shift and, moreover, the viewing range which is able to display the white color becomes narrower. This situation is shown in Fig. 4(a). In this figure, a projection light is denoted as 711 and the incident main wavelength thereof is denoted as λ and a wavelength shifted from this is denoted as λ 1. Due to the wavelength difference between λ 1 and λ the light is diffracted, respectively, in different directions by holography 700.

To solve this problem, diffraction range for each color must be overlapped by carrying out multiple exposures with different wavelengths on the hologram screen or by layering a plurality of layers. However, even in the case that a hologram is formed with the wavelengths representing the so-called the three primary colors or red, green and blue, it is difficult to make the viewing ranges effectively coincide for all components of the light included in light entering from the actual projector-type image display means. Therefore, color reproduction in the case of an enlarged display is particularly poor and a disadvantages such as different colors between the right and left sides arise. In addition, a hologram screen is extremely expensive because of the time and effort needed for multiple exposures or the like.

That is to say, in an image display device utilizing a conventional holographic screen functions are exercised based on the wavelength dependence or on the phenomenon of diffraction which is dependent on the angle and, therefore, it is difficult to display a large, bright image with excellent color reproduction.

In addition, though it is not precisely a projection technology of images, a light control element using a thin film, such as a hologram, has been examined in applications as a means for improving the quality of image display devices. For example, in a reflective-type liquid crystal display device contrast reduction and reduction of the visual observability occur because a light entering from outside is reflected on the surface and is observed at the same time as the image and, therefore, in order to improve this a hologram is installed on the incident surface of the external light as disclosed in SID98 DIGEST pp. 1139-1142.

Here, in this hologram the external light entering from a particular angle is diffracted to deviate in a particular direction so as to be an incident light to the reflective-type liquid crystal display device. And, thereby, an image outputted after modulation by the reflective-type liquid crystal display device and a directly reflected light from the surface of the light entering side are separated. In addition, there is also the case where the hologram, itself has a scattering function in order to broaden the range wherein a displayed image can be observed clearly (Japanese Unexamined Patent Application Publication No. Hei 8-202248).

In the case of a light control element using solely a hologram, color reproduction of the image cannot be prevented from becoming poor and it is difficult to display the tint having fidelity to the original image. That is to say, a hologram is wavelength dependent with respect to the diffraction efficiency. Therefore, a diffracted light which becomes an incident light to the reflective-type liquid crystal display device after deviation by the hologram ordinarily has a different wavelength spectrum from the external light which is almost a white color light, such as sunlight, or light from a florescent lamp.

For example, in the case that a hologram is formed by a green color laser beam (for example, a wavelength of 514.5 nanometers), the diffraction efficiencies for the colors of red and blue are reduced resulting in an incident light with a preponderance of green. Therefore, a white color image cannot be prevented from having a preponderance of green.

To solve this problem, it is considered that multiple exposures should be carried out with different wavelengths (for example, with the so-called three primary colors red, green and blue) or a plurality of layers are layered so as to overlap the diffraction ranges of each color. In the case of multiple exposures, however, the formed interference rings become complicated so as to form a dark image failing to realize high efficiency. Layering is also expensive and the production (manufacture) thereof is difficult. Particularly, in the case of a transmissive type hologram formed through layering, the wavelength dependence of the diffraction efficiency changes in a relatively gradual manner and, therefore, when attempting to make each layer selectively correspond solely to one primary color other colors are also diffracted at the same time. For example, a hologram formed for the color of red diffracts the colors of green and blue at the same time so that those two colors are diffracted in different directions, which are different from the desired direction, resulting in loss of efficiency.

That is to say, it is difficult to make the image observability ranges for the light of all the wavelengths entering from the projector-type image display means coincide effectively. Particularly, color reproduction of the case where the screen is enlarged for show window display or the like is poor and the colors are different on the right and left sides. Moreover, time and money are consumed for multiple exposures or the like and, therefore, the hologram screen is very expensive.

Therefore, it is considered that a light control film utilizing scattering instead of diffraction should be used as a screen. In the case of scattering, though the color reproduction is excellent because there is no wavelength dependence, the positions for the observation of the brightest image are on the line connecting the projector-type image display means and the screen. This is described in reference to Fig. 4(b). An image projected by a projector-type image display means 502 is formed on a scattering screen 501. As a result, though a projected image is displayed on the scattering screen 501, the brightest image is gained not in the direction perpendicular to the screen but, rather, in the direction of light entrance and, therefore, the viewer 506 must observe the image from above. Thereby, a limitation arises as to the arrangement of the respective devices.

Thereby, a bright image cannot be observed unless the viewer looks into the screen diagonally from above (below) when the image is projected diagonally from below (above) for the convenience of installment of the projector-type image display means. Therefore, even in the case that an image is displayed to draw attention in a show room, viewers can observe the image only in the case that they are in a position from which they can look into (look up to) the projector-type image display means and, therefore, it is difficult for passers by to notice the image display of which the function as an advertising medium is thus not sufficiently exercised.

Prior to the above, the configuration where an image projected from a projector, which is hung from the ceiling, is displayed on a glass window diagonally below the projector so that passers by look up at this image is, in many cases, not preferable from the point of view of the safety of the passers by, and is not generally utilized in a show room or the like facing onto, for example, underground malls or a hallway inside of a large building wherein an image is displayed in a high position so as to be looked into from below.

### [Next, the problems of the background technology are described.]

A lighting device using an integrator formed of a pair of lens arrays, however, secures the uniformity of the brightness of the object light so as to enhance the light utilization efficiency, of which the production is complicated and difficult, lowering the yield of the production while the mould and the grinder are expensive, resulting in high cost.

In the case that a spherical mirror is used in order to improve the mirror solid angle rate,
(1) light condensation loss cannot be prevented from occurring because light returning from the spherical mirror does not necessarily pass through the focal point of the ellipsoidal mirror due to the glass bulb tube covering the light emitting body of the light source.
(2) It is impossible to make the mirror solid angle rate 100%, or close to it, because of the limitation to the range covering the spherical mirror so as to avoid the eclipse of a light bundle condensed on a second focal point (F2) of the ellipsoidal mirror.
(3) The lifetime of the light source is shortened since the temperature thereof is raised because a light bundle which has once been outputted is returned to the vicinity of the light emitting body of the light source.
(4) Not only the cost, but also the weight, increases dramatically because a spherical mirror is newly added.

In addition, when an image is displayed utilizing a hologram or the like, not only is there a problem with the cost or the like as described above but, also, the essential functions have not yet been sufficiently achieved because of narrow viewing angle, difficulty of reproducing colors, limitation of the arrangement or the like.

### Disclosure of the Invention

The present invention has the purpose of solving the above described problems and is provided for the light source side of apparatuses or for the display side of apparatuses. More concretely, the means thereof are provided as follows.

### [First Group of Aspects of the Invention]

The first group of aspects of the invention relates mainly to the improvement on the light source side.

One aspect of the invention provides a lighting device having an optical element for diffraction wherein a plurality of microscopic regions are arranged two dimensionally and having a lens array in a form similar to the optical element in order to uniformly illuminate the screen, the photosensitive material or the like in the lighting device used for the light source of a liquid crystal projector.

And each of the microscopic regions of the optical element for diffraction and the fly eye lens correspond (in principle) one to one and a light bundle from the light source which has entered into the former enters to the latter as a bundle of converging rays and, moreover, reaches the object to be eliminated (though described here as "object," a region, a place or the like are, of course, included). Thereby, a lighting device which is inexpensive and has an excellent uniformity of the light bundle is provided.

Here, this lighting device, in principle, has a mirror, such as ellipsoidal mirror or a parabolic mirror, except for the case where there is some specific reason and, moreover, each of the microscopic regions of the optical element for diffraction is in a form which is, of course, preferable from the point of view of light utilization, such as in a shape similar to a plane shape of the object to be illuminated, except for the case where there are some specific purposes such as to draw attention using a screen or the like for advertising.

In addition, one aspect of the invention has a polarized light separation means and a polarization plane rotating means in order to improve the light utilization efficiency, especially in the case that a polarized light transmission means, such as a liquid crystal projector, exists for control of the light transmission utilizing a polarized light on the downstream side of the projection light. Then, the polarized light separation means separates the polarized light transmission means located to the downstream side of the forwarding direction of the light (on the downstream side) into a polarized light component which passes through without change and a polarized light component which doesn't pass through in the case when it is open (ON) so that the light of the former component passes through, without change, in the direction to the downstream side. On the other hand, the light of the latter component is separated. Then, a polarization plane rotating means rotates the polarization plane of this separated polarized light component 90 degrees (in principle) so as to become a polarized light component which passes through and this rotated light is allowed to pass through in the direction to the downstream side.

In addition, one aspect of the invention is devised so as to have the optimal incident angle according to each wavelength since an optical element for diffraction changes in the transmission dependence of the incident angle due to the wavelength. Accordingly, at the time of manufacturing an optical element for diffraction, such as a hologram, the effects of the invention become particularly evident in the case that an angle made between the reference light and the object light is large for the application thereof. Moreover, in this case, the light is separated, in principle, into the three primary colors of red, green and blue so that each of the primary colors has the optimal incident angle to the optical element for diffraction though it depends on the application of the lighting device or the type of the light source. Here, the angle, arrangement, reflectance or the like may be devised so that the light has coloring close to the sunlight depending on the conditions of the color and temperature of the light source such as a high pressure mercury lamp, a carbon arc electrode lamp or an incandescent electric lamp.

In addition, one aspect of the invention adopts a dichroic mirror as a color separation means. Therefore, a dichroic mirror for each color is arranged so that the light makes the optimal angle with the optical axis from the light source corresponding to the color of the object from which the light is reflected and in the order determined from the wavelength of the target color (in principle). In addition, the reflected light of each color is projected onto the optical element for diffraction (at almost the same angle in principle). Each dichroic mirror allows colors different from the reflection target to pass through and this light of the color which has passed through enters into the dichroic mirror on the downstream side.

Here, at this time, the dichroic mirror on the downstream side practically doesn't have a light bundle of the color to be passed through and, therefore, may be a mirror of general purpose or a mirror dedicated for the color such as a simple mirror or a grating mirror (there equally included in the present invention).

In addition, one aspect of the invention has an optical element for diffraction in order to adjust the incident angle by bending the optical axis so that a light bundle from the light source (including a mirror or a reflector) has the optimal incident angle to the first lens array on the upstream side of the optical element for diffraction serving as the first fly eye lens. Therefore, it becomes possible to arrange the light source and the optical element for diffraction serving as the first fly eye lens array in, substantially, a line form. Thereby, the device becomes compact.

In addition, in one aspect of the invention, the lighting device having a light source and a reflection mirror for condensing light (light from the light source is effectively utilized. Accordingly, it is not limited to condensation into one point, or the like. For example, for the parabola mirror it becomes a parallel light.) is provided with a thin diffraction means at the opening part of the reflection mirror or in the downstream (on the side of object to be illuminated). Then, this diffraction means allows the light bundle which has been reflected once from the reflection mirror to pass through, without change, since it enters perpendicularly, or at an angle close to this, (though it may be in the direction of spreading a minor amount or slightly narrowing toward the light axis in the form of an ellipsoidal surface depending on the type of the reflection mirror or the like). On the other hand, a light bundle directly from the light source which is supposed to not be reflected from the reflection mirror but, accordingly, to deviate outside from the opening part enters into the diffraction means at an angle diagonal to a certain amount (large) (slightly spreading with respect to the light axis) and, therefore, is bent so as to move toward the direction of the object to be eliminated. And, thereby, the mirror solid angle rate and, accordingly, the light utilization efficiency increase.

Here though, in principle, this thin diffraction means is provided so as to be perpendicular to the light axis connecting the light source and the object to be illuminated, a peripheral part of the reflection mirror is rounded (three dimensionally rounded) or no light has passed through the metal clasp located just behind the light source along the optical axis in many cases and, therefore, a hole may, of course, be provided in the center for further releasing heat in such cases. In addition, other optical elements for condensing light such as a convex lens or a fresnel lens may also, of course, be provided if necessary according to the situation.

In one aspect of the invention, the light bundle which is once reflected from the reflection mirror and illuminates the object to be illuminated and the light bundle which is diffracted by the diffraction means mainly at the outer periphery part of the opening part of the reflection mirror and illuminates the object to be illuminated differ in a variety of characteristics such as in an angle made with the optical axis. Therefore, the reflected light bundle is appropriately led to the object to be illuminated in accordance with the characteristics. Then, an optical system located on the light axis side (center) and an optical system on the outer periphery side which appropriately leads the diffracted light bundle to the object to be illuminated are provided.

Here, at this time, it is preferable for those optical systems to be formed of an optical system having a pair of lens arrays or a pair of an optical element for diffraction and a lens array from the point of view of the light conversion or the like. In addition, it is preferable, from the point of view of making the manufacturing device compact, for the lenses of the optical axis side and of the outer periphery side to have the same plane in common.

In addition, in one aspect of the invention, the integrator of the light axis side which collects a light bundle reflected from the ellipsoidal mirror appropriate to condensing light in the sense of condensing light particularly in one dot or in a small region has an optical element of upstream side such as an optical element for diffraction of a lens array wherein a plurality of microscopic regions are arranged two dimensionally and an optical element of the downstream side such as a lens array wherein the microscopic regions are, in the same way, arranged two dimensionally. Therefore, the light bundle from the light source illuminates the object to be illuminated with high precision and uniformity.

Here, in this case, it may also; of course, have other optical elements such as a condenser lens if necessary (it may rather be a principal to have such elements).

In addition, in one aspect of the invention, the integrator of the outer periphery side which collects the light bundle which has not been reflected from the ellipsoidal mirror has an optical element of the upstream side such as a lens array wherein a plurality of microscopic regions are arranged two dimensionally or an optical element for diffraction and an optical element of the downstream side such as a lens array wherein microscopic regions are arranged two dimensionally in the same way. Therefore, the light bundle which is, originally, not supposed to be utilized because it deviates through the mirror opening part illuminates the object to be illuminated with high precision and uniformity.

Therefore, in the case of usage in semiconductor devices, light of high energy density illuminates the central part and the outer periphery part of the optical axis of the object to be illuminated in a substantially uniform manner and, thereby, exposure time can be shortened.

In addition, in one aspect of the invention, the optical elements of the optical system are formed by microscopic lenses which are of a similar shape to the object to be illuminated or in a shape close to this and which are arranged two dimensionally and each of the microscopic lenses forms a pair between the upstream side and the downstream side in the same way as in a conventional lighting device so as to allow a light bundle to enter into the object to be illuminated with high precision and uniformity.

Thereby, precision, uniformity, light utilization efficiency or the like are improved greatly.

In addition, in one aspect of the invention, there exists an apparatus or the like, such as an ordinary (not a high polymer diffusion type) liquid crystal display, of the downstream side of the lighting device which utilizes polarized light so as to display an image or to open and close (turn on and turn off) the light path. Then, in order to improve the display characteristics, brightness or the like of this apparatus the two integrators of the lighting device have a polarized light separation means and a polarization plane rotating technology.

Then, the polarized light separation means separates the light from the light source (including the reflected light) into a polarized light component appropriate to (passing through) the above described apparatus when it is open and a polarized light component perpendicular to this polarized light component so that the former component passes through without change while the latter component is separated through the reflection or the like. Next, the polarization plane rotating means rotates this separated component 90 degrees (may, of course, include a small amount of error) so as to have the same degree of polarization as that of the composition light which passed through as described above. Then, this rotated polarized light component also, of course, enters to the above described apparatus. Thereby, the effects become evident such that the display of the liquid crystal display device becomes brighter.

Here, in the case that the optical device for condensing light of the downstream side has polarized light dependence for the light which has passed through, the effects of the present invention become evident: In addition, in the case of usage in the light source for a display device which does not use polarized light such as a movie film, it may be interchangeable with other parts of the configuration.

In addition, in one aspect of the invention, the diffraction means provided at the opening part of the reflection mirror is inexpensive because of its ease of manufacture and is a hologram of light weight.

In addition, in one aspect of the invention, at least one optical element of at least one of the integrators of the center side and the outer periphery is an inexpensive hologram lens. Here, in this case, for example a holographic lens wherein microscopic lenses are arranged in a plane (two dimensionally) is provided on the upstream side while a fly eye lens is provided on the downstream side.

### [Second Group of Aspects of the Invention]

The second group of aspects of the invention mainly relate to the apparatus side for displaying an image.

One aspect of the invention is provided with a screen film having a scattering anisotropy with respect to the angle of the incident light attached to a screen such as a glass which is transparent, or almost transparent, (it may be slightly tinted) which also works as part of the case of a show window and also is provided with a means for changing the angle of the proceeding light such as a fresnel (diffraction) lens provided closely on the opposite side to the incident light, in principle.

Then, in the case that the projector type image display means (device) projects an image light onto the screen, the light bundle does not pass through the screen without change because of the incident angle and scattered on the surface and they are arranged in the position where an image is formed so as not to be able to be observed from the opposite side to the light source. And, thereby, when an image light is projected from the projector type image display means an image with very bright color and excellent reproduction is displayed on the screen even in a slightly bright place for passers by.

At this time, a fresnel lens is arranged on the reflected light side of this screen (though in many cases the glass of the show window or a reflection prevention film exist in between, in principle substantially through close contact especially in the case of show windows).

Then the fresnel lens of which the focal point is in the vicinity (the position from where the image doesn't become practically out of focus or doesn't become hard to be seen. Accordingly, including the same position.) of the projector type image display means turns (because of the condensation of light) this scattered light (almost) parallel to the viewer. Thereby, a bright image with excellent color is displayed on the show window or the like.

And, of course, when the projector type image display means does not project an image the exhibitions or the like in the show window can be seen as they are since the scattering screen is positioned at the height of the eye of the viewer or at a position close to that in many cases and, therefore, allows the light from the exhibitions entering almost perpendicular to the scattering screen to pass through with (almost) no change by, for example, moving the fresnel lens upward.

In addition, in one aspect of the invention, the gap between the (convex) fresnel lens and the scattering screen is made the focal distance of the fresnel lens or less and, thereby, an enlarged image is displayed at the time of the observation.

Here, because of the location of the hallway (street) when the distance between the show window or an image displayed thereon and a viewer is within a specific range it is more preferable to set the focal distance of the fresnel lens by taking this into account. In addition, a reflection prevention film or the like is formed on the glass, fresnel lens, scattering screen or the like of the show window, if necessary.

In addition, in one aspect of the invention, light deviation means of the hologram which diffracts the scattered light into the direction preferable for display is provided on the surface of the back (opposite side to the light source or the viewer side) of the screen having a scattering anisotropy with a close contact in principle in order to nullify the loss due to the reflection of light or the like (without providing an air layer or the like in between. Here, in the case that a transparent glass plate or, additionally, a reflection preventive film or the like exist between the scattering screen and the hologram the situation is included in that with a close contact.). In addition, the projector-type image display means is arranged in a position making an angle with the direction to the screen from which the projection light is scattered. Then, when an image light is projected on the scattering screen the image light is scattered and, thereby, an image with bright color and excellent reproduction is displayed. Moreover, the hologram on the back surface of the screen bent the image light into the direction optimal for the viewer.

Here, when the projector-type image display device doesn't project an image light it becomes possible for the viewer to see merchandise exhibited within the show window via the hologram, the screen having scattering anisotropy or the like. Here preferably, from the point of view of cost or the like, this hologram is manufactured through interference exposure by two light bundles which are coherent.

In addition, in one aspect of the invention the hologram on the back side of the scattering screen has substantially the same angles of the incident angle of the reference light at the time of manufacturing and of the projection light from the projector-type image display means (more concretely, ± 14° or less from the point of view of the viewing angle and ± 7° or less from the point of view of excellent image are preferable. It also includes the case where they are the same.) and the incident angle of the object light and the image display range substantially coincide (more concretely, ± 10 (= tan 14°) or less more preferably ± 12 (= tan 7°)% or less and even more preferably ± 6% or less). And, thereby, improvement is gained from the point of view of brightness, reproduction of colors and freedom of arrangement of each apparatus at the time of actual usage.

In addition, in one aspect of the invention the angle of scattering the incident angle of the scattering screen and the incident angle to the object to be a reference for the hologram are substantially equal (more concretely, ± 14° or less, preferably ± 7° or less and more preferably ± 3° or less). Thereby, excellent display and increase of the freedom of the arrangement of each apparatus can be gained.

In addition, in one aspect of the invention, because of the image display device utilizing a hologram which is excellent in the reproduction of colors and in the brightness of the image, incident direction of the laser beam or the object light at the time of forming a hologram the arrangement or the selection of the functions of the scattering screen are devised. More concretely, in one aspect of the invention the object light made to be either converging light or diverging light at the time of forming a hologram taking the usage modes or conditions of the image display device into consideration.

In the same way, in one aspect of the invention, a changing means for changing (diffracting) the proceeding direction of light into the downstream (the opposite side to the light source of the scattering anisotropic screen is provided.

The production method of the holograms according to those aspects of the invention is characterized in that the second scattering screen is arranged on the incident surface of the laser beam of the hologram recording material, an object light is made to enter from the range of the scattering angle and interference rings formed by making the reference light to enter from out of the range of the scattering angle is recorded on the hologram recording material. Only the object light can be scattering light due to the above described arrangement and, therefore, a hologram reproducing the scattering light can be easily formed.

In order to enhance the diffraction efficiency, it is preferable to make the incident angle of the reference light substantially equal to the incident angle at which the projector-type image display means enters an image onto the scattering screen. At the same time, by making the incident angle of the object light to be out of the range of the scattering angle of the scattering screen a hologram wherein the inside of the glass substrate can be observed at the time of no image display can be gained.

In the case that a hologram, which is installed on the light reflecting member, is formed the incident angle of the reference light is made to be substantially equal to the incident angle at which the projection image of the projector-type image display means enters from the back side of the scattering screen after being reflected from the light reflecting member (there may be an error of approximately 5 degrees, preferably 2 degrees or less, for the convenience of the arrangement of apparatuses.).

In the case of combining any member of a transparent member such as glass or a light reflecting member such as a mirror a hologram which deviates the incident image in the direction perpendicular thereto is formed by using a scattering screen which selectively diffuses solely the incident light from the direction perpendicular thereto as the second scattering screen. By using this a bright image can be observed from the front of the screen.

Thereby, the scattering screen scatters the projected image light so that the deviation means turns this projected and scattered light in the direction to the viewer who is on the downstream side. Therefore, the viewing range is expanded.

Here, the object light entering into the second scattering screen may be either converging light or diverging light, which can be changed according to the range wherein an image is displayed. That is to say, by making the object light to be a converging light, though the range from where an image can be observed becomes narrower, it becomes possible to a display bright image. On the contrary, by making the object light to be a diverging light, though image is dark, the image can be observed from a broader range.

In addition, in one aspect of the invention the diversion means is a fresnel lens which is thin, light and inexpensive.

In addition, in one aspect of the invention the diversion means is a hologram which is thin, light and inexpensive.

In addition, a reflecting member is provided on the back side of the scattering screen which has an anisotropy of the incident angle (without having, at least, an air layer in between in principle) and the projector-type image display means is provided in a position wherein the scattering screen scatters, at least, either a direct incident light due to the incident angle or an incident light from the back side which has been reflected from the reflecting member on the back side (the side opposite to the light source). Moreover, it is possible to observe the image from a broader angle. And, in this case, the scattering screen may be a half mirror. In this case, particularly, it becomes possible to observe the image from both sides of the half mirror when the incident light is scattered.

And, though as a practical problem, the scattering screen, the reflecting member and the glass plates which secure and support these have thickness, blurring of the image or the loss of focus of the image caused by the thickness do not, of course, become the problem in the case of the comparison with the size and precision of the image seen by the viewer.

In addition, in one aspect of the invention, a thin deviation means is provided on the front side of the scattering screen (the side of the projector-type image display means or the viewer). Then, this deviation means allows an image light projected (entered) from the projector-type image display means to pass through without change (practically no reflection and no scattering are involved) so that the reflected light and the scattered light entered from the back side is turned to the direction of the viewer side.

In addition, in one aspect of the invention, the hologram as a deviation means, more particularly, an optical element for diffraction is manufactured by taking the incident angle of the image light which is projected at the time of usage into consideration with respect to the incident angle to the object to be referred to.

In addition, in one aspect of the invention, the light control element has a scattering screen having scattering anisotropy and a light deviation means arranged on the back side thereof (opposite side to the light source). Then, it is preferable for this light deviation means to be an optical element for diffraction, particularly a hologram in the same way as each of the above described aspects of the invention from the point of view of price, weight, characteristics of the image or the like. Moreover, in the same way the hologram is manufactured by taking the usage conditions as the light control element into consideration with respect to the incident angle, interference or the like of the interference light.

In addition, in one aspect of the invention, a scattering screen having a scattering anisotropy with respect to the incident angle, a light deviation means for diffracting the incident light and a light control element having a reflecting means are utilized for the display part of the reflective-type liquid crystal display element. Thereby, the external light reflected from the surface of the display part is turned in the direction so as not to come into the eye of the viewer of the display surface while the light reflected from the reflecting means for displaying is turned in the direction so as to come into the eye of the viewer.

### Brief Description of the Drawings

Fig. 1 is a view showing the configuration and the principle of a lighting device according to a prior art used in a lighting optical system of liquid crystal projectors, a projection aligner for manufacturing ICs or the like;
Fig. 2 is another example of the above described lighting device according to a prior art;
Fig. 3 is an example showing a technology attempting to increase the mirror solid angle rate in the above described lighting device according to a prior art;
Fig. 4 shows the cause of the defects due to diffraction in a holographic screen according to a prior art, an example of a technology attempting to eliminate this and the configuration thereof;
Fig. 5 is a configuration view of a lighting device as the first (1-1) mode (embodiment) of the first aspect of the invention;
Fig. 6 is a plan view of an optical element for diffraction according to the above described mode;
Fig. 7 is a view showing, a manufacturing procedure for exercising diffraction effects of an optical element for diffraction according to the above described mode;
Fig. 8 is a view showing the principle for exercising the functions of an optical element for diffraction according to the above described mode;
Fig. 9 is a view showing the configurations of a lighting device and a projector-type image display device using the lighting device of the first (1-2) mode of the present invention;
Fig. 10 is a view showing a configuration of a polarized light conversion element used in the lighting device of the above described mode;
Fig. 11 is a view showing the configurations of a lighting device and a projector-type image display device using the lighting device of the first (1-3) mode of the present invention;
Fig. 12 is a view showing entrance angle dependence of the diffraction efficiency of an optical element for diffraction used in the lighting device of the above described mode for each particular wavelength (each primary color);
Fig. 13 is a configuration view showing another lighting device as the first (1-4) mode and a projector-type image display device using the lighting device;
Fig. 14 is a configuration view of the mode using the optical element for diffraction for improving the mirror solid angle rate of the reflector;
Fig. 15 is a view showing an illumination method of a reference light and object light for forming interference rings recorded in a particular region of the optical element for diffraction used for improving the mirror solid rate of the light device;
Fig. 16 is a view for describing the functions of the optical element for diffraction in the lighting device of the above described mode;
Fig. 17 is a view of another application (modification) example of the lighting device of the above described mode;
Fig. 19 is a view showing the situation where the functions and effects of the second (2-1) mode of the present invention are exercised;
Fig. 20 is a view showing the situation where, in the same way, the functions and effects of the second (2-2) mode are exercised;
Fig. 21 is a view showing the configuration of the second (2-3) mode;
Fig. 22 is a view showing the relationships with interference light or the like at the time of manufacturing a hologram in the above described mode;
Fig. 23 is a view showing the principle exercising the effects of the above described mode;
Fig. 24 is a view showing a production method of a hologram screen having a scattering function in the above described mode;
Fig. 25 is a view showing a configuration of a reflective-type hologram screen as the second (2-4) mode of the present invention;
Fig. 26 is a view showing a production method of a hologram screen having a scattering function in the above described mode;
Fig. 27 is a view showing the principle and the configuration of the second (2-5) mode of the present invention;
Fig. 28 is a view for describing the difference of the effects between a light control element (a) according to a prior art and a light control element (b) according to the above described mode;
Fig. 29 is a view for describing the case where scattering light is used as an object light of a hologram;
Fig. 30 is a view showing the incident wavelength dependence of the diffraction efficiency by a hologram;
Fig. 31 is a view showing the entrance angle dependence of the diffraction efficiency by a hologram;
Fig. 32 is a view showing the situation of the exposure to light for manufacturing a hologram in the above described mode;
Fig. 33 is a view showing a cross section of a reflection part of an image display device as the second (2-6) mode of the present invention;
Fig. 34 shows views of modified examples of the first (1-1) mode (a) and the first (1-4) mode (b);
Fig. 35 shows views of modified examples of the first (1-3) mode (a) and the first (1-5) mode (b);
Fig. 36 is a view showing another modified example of the first (1-5) mode; and
Fig. 37 is a view showing another modified example of the second (2-1) mode.

### (Explanations of Reference Numerals)

- 1010: second optical element for diffraction
- 101: optical element for diffraction
- 1011: microscopic region of optical element for diffraction
- 1012: effective region of optical element for diffraction
- 1013: specific region of optical element for diffraction
- 102: lamp
- 103: reflector
- 1031: ellipsoidal mirror
- 1032: half mirror
- 104: (first) lens array
- 1040: first lens array (center)
- 1041: microscopic lens array
- 1042: first lens array (outer periphery side)
- 105: (second) lens array
- 1050: second lens array (center)
- 1051: microscopic lens array
- 1052: second lens array (outer periphery side)
- 106: object to be illuminated
- 1061: transmissive type liquid crystal panel
- 107: condenser lens
- 108: projection lens
- 112: light reflected once from a spherical lens
- 113: spherical lens
- 120: polarized light exchanging element
- 121: polarized light separation element
- 122: P polarized light
- 1221: converted P polarized light
- 123: S polarized light
- 124: reflection means
- 125: polarization plane rotating means
- 130: light deviation means
- 140: dichroic mirror (ultra violet ray)
- 141: dichroic mirror (blue)
- 142: dichroic mirror (green)
- 143: dichroic mirror (red)
- 200: hologram
- 500: plate of reflection part (mirror)
- 501: scattering screen
- 502: projection type image display means
- 503: scattering screen (mode)
- 504: fresnel lens
- 506: viewer
- 700: holographic (hologram screen)
- 701: hologram manufacturing sample for reference
- 7011: material for hologram
- 702: reference light
- 703: plane wave
- 704: object light
- 705: hologram for reference
- 706: sample of optical element for diffraction
- 707: reproduction light conjugated with reference light
- 708: conjugated reproduction object light
- 709: second reference light
- 710: second reproduction light
- 711: projection light
- 712: white external light
- 7121: surface reflection light of external light
- 7122: reflection light of external light
- 713: polarization plate
- 714: ITO
- 715: color filter
- 716: liquid crystal layer
- 800: substrate

### Best Mode for Carrying Out the Invention

The present invention will now be described based on embodiments (examples).

Here, (1-i) is a first embodiment for explaining a first invention group. A first embodiment for explaining a second invention group will be denoted as (2-i).

### [First Group of Aspect of the Invention]

### (Embodiment of 1-1)

This embodiment uses a diffractive optics instead of a first lens array in order to reduce the cost and weight of the lighting device.

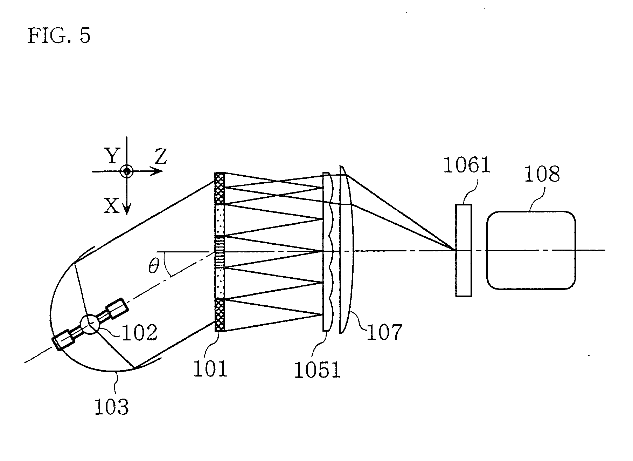

Fig. 5 shows a construction of the lighting device in this embodiment. The bundle of light output from a lamp 102 is reflected by a reflector 103, and enters into a diffractive optics 101 at a predetermined angle θ shown in Fig. 1. This diffractive optics is divided into small areas, and each area condenses the incident bundle of light to corresponding small lenses of a lens array 1051. Each lens constituting the lens array forms an image in each corresponding small area on an object to be illuminated 106 via a condenser lens 107.

That is to say, since the diffractive optics adequately refracts the incident light by means of the incident angle, it plays a role of the lens array. Therefore, the diffractive optics acts as an integrator by forming a pair with the lens array, to thereby play a role of efficiently condensing rays of light, while increasing uniformity in brightness of the illumination light on the object to be illuminated.

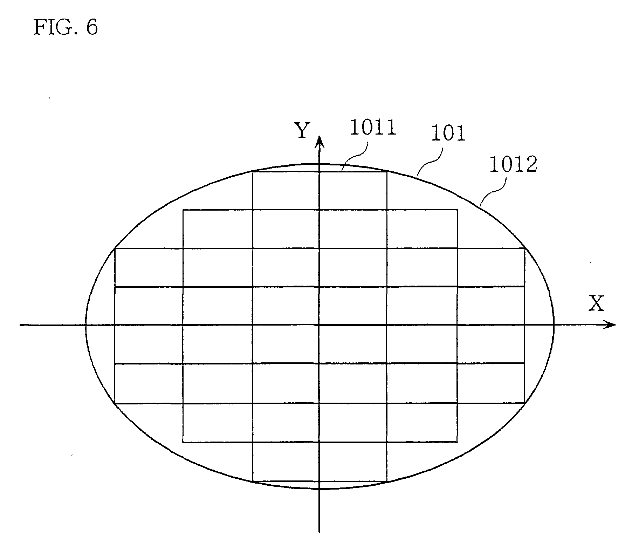

Fig. 6 shows a planar shape of this diffractive optics 101. As described above, images in each small area 1011 are superimposed on the object to be illuminated, to thereby increase uniformity in illuminance in each section. Accordingly, it is preferable that each small area has a substantially similar shape as that of the object to be illuminated. Moreover, the bundle of light reflected by the reflector is substantially circular. However, when the optical axis of the reflector shown in this embodiment and the optical axis that can be defined as a normal of the diffractive optics intersect at an angle of θ, the image of the bundle of light projected onto the diffractive optics becomes elliptic, designating the x-axis as the major axis. Therefore, it is desired that in the diffractive optics, the small areas be arranged in the effective area 1012 of the ellipse without any gap.

In general, since the aspect ratio of the image is 3:4, or 9:16 to give a rectangle with the lateral side being long, when the diffractive optics is used for image display, it is preferable that this effective area also has a rectangular shape with the lateral side being long.

The diffractive optics per se used in this embodiment will now be described.

This diffractive optics is a phase-type volume hologram element produced by two-beam interference exposure or CGH (computer-generated hologram). Both of transmissive type and reflective type are possible, and the diffractive optics shown in Fig. 5 is a transmissive type.

The hologram material used in this diffractive optics includes general hologram materials, such as silver salt emulsion (bleach type), photorefractive crystals of iron-doped lithium niobate or the like, gelatin bichromate, or photopolymer; photoresist for recording interference fringes as changes in unevenness (these are formed by electron beam drawing, ion beam etching, embossing or the like), photo-thermoplastic, UV curable liquid crystals (Japanese Patent Application No. Hei 9-327769), a mixture of a liquid crystal polymer and photoresist (Japanese Patent Application No. Hei 9-319346). In this embodiment, a photopolymer is used.

The production method of this diffractive optics will now be described.

It is also possible to record interference fringes calculated by electron beam drawing or the like on the photoresist, but in this embodiment, a method of recording interference fringes directly on the photopolymer is adopted.

In general, the hologram is produced by exposing interference fringes created by making coherent two beams such as laser beam interfere on a recording material such as photopolymer. Here, coherent two beams mean separated two (in principle) bundle of lights in which interference fringes can be formed.

Specifically, the diffractive optics is prepared (produced) in the following manner.
(1) Laminate a photopolymer on one side of a clean glass substrate to give a sample. (One obtained by coating a reflective protection film on a light incident plane of the glass substrate may be used.)
(2) Irradiate coherent two beams onto the aforesaid sample that is left stand still. (One of the two beams becomes a reference light and the other becomes an object light.)
(3) Effectuate exposure until an energy of about several tens to several hundreds milli-joule per square centimeter is obtained. At this time, photopolymerization progresses in the photopolymer depending on the strength of the interference fringes, to thereby form a refractive index distribution depending on the strength of the interference fringes.
(4) Irradiate strong UV rays onto the photopolymer at the time when a predetermined refractive index distribution depending on the interference fringes arises, and let the reaction progress, while keeping the refractive index distribution as it is, to thereby secure the refractive index distribution.
(5) Perform a baking processing at 120°C for about two hours, to thereby increase only the refractive index difference, while keeping the refractive index distribution.

The diffractive optics is prepared in the above-described manner. In this embodiment, to increase reliability, in particular, durability and environment resistance, a UV seal processing is performed between the processing of (4) and (5) described above. This is to cure a UV curable resin, after the UV curable resin is uniformly coated in a thin film on the surface of the photopolymer, and the upper surface is further covered with a glass substrate. As a result, the photopolymer is inserted between the glass substrates on the front and the back, via the UV curable resin. (Therefore, though it is not related to this embodiment, when this diffractive optics is used for, for example, a windshield of a vehicle such as a patrol car, it is possible to perform a function of preventing the glass from scattering at the time of an accident, as well as displaying various information. Moreover, in window glasses also having a function of displaying images for propaganda and advertising for passer-by of buildings in a business area, it is also possible to perform a function of thermal insulation.)

If light enters into the diffractive optics prepared in this manner from the same direction as the reference light at the time of interference exposure, an object light is reconstructed. Here, the incident light at this time is referred to as reconstructed light, and the light to be reconstructed is referred to as a reconstructed object light.

The role or function of the diffractive optics in this embodiment is to use the reconstructed light as the output bundle of light from the light source, and to output converging rays as the reconstructed object light, equivalent to that of the first lens array in the conventional integrator.

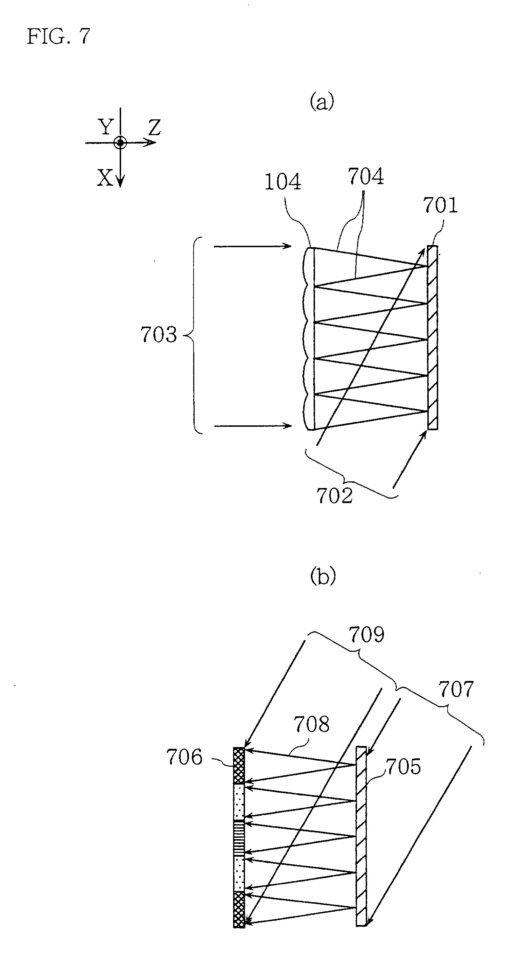

Next, the production procedure for exerting the diffraction effect of the diffractive optics will be described, with reference to Fig. 7.

As shown in Fig. 7(a), interference fringes formed by letting the reference light 702 and the object light 704 formed, for example, by entering the plane wave 703 into the lens array 104 interfere are recorded on a reference hologram preparation sample 701. At this time, the fly eye lens 104 is the first lens array constituting the conventional integrator, which is to be replaced by the diffractive optics.

Fig. 7(b) shows the manner that a sample 706 for the diffractive optics is exposed by using the reference hologram 705 prepared by the above-described interference exposure.

That is to say, a reconstructed light 707 conjugate with the reference light is made to enter into the reference hologram. Then, a conjugate reconstructed object light 708 is reconstructed from the reference hologram. Interference fringes of this conjugate reconstructed object light 708 and the second reference light 709 (not necessarily the same angle as that of the conjugate reconstructed light 707) are recorded to thereby prepare the diffractive optics.

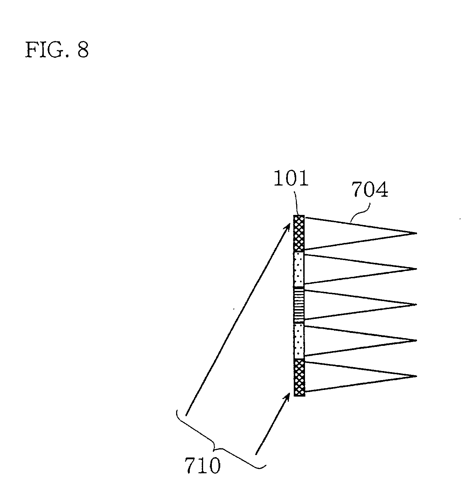

At the time of reconstruction, if the second reconstructed light 710 conjugate with the second reference light enters, as shown in Fig. 8, an object light 704 obtained when the plane wave enters into the first lens array is reconstructed. Actually, as the second reconstructed light, the output bundle of light from the lamp may be used.

If the first lens array is designed with respect to converging rays, that is, to a light source using an ellipsoidal mirror as a reflector, the output bundle of light when the converging rays enter into the fly eye lens instead of the plane wave may be used as the object light at the time of preparing the reference hologram.

In actual production, if only the reference hologram is produced, exposure of the diffractive optics is performed in the optical system shown in Fig. 7(b). The time required for this exposure depends on the output of the laser beam, but generally, is about 10 to 60 seconds, and hence, the preparation process is simple and easy.

Therefore, yield is high. As a result, the material cost and production cost become quite cheap, compared to the fly eye lens that is prepared by making a mold. Specifically, the diffractive optics can be produced at a cost of less than one tenth the production cost of the lens array.

At this time, it is preferable that the incident angle θ of the second reconstructed light be 30° or more. This is because the diffractive optics is to be a so-called volume type hologram (a hologram several times thicker than the pitch of the recorded interference fringes), in order to propagate the object light to be reconstructed at high efficiency in the direction of the z-axis in the figure, that is, in the direction of normal of the lens array and the diffractive optics.

When the lighting device in this embodiment is used as a projection type image display device, as shown in Fig. 5, for example, a transmissive type liquid crystal panel 1061 is used as an object to be illuminated, and the output thereof is projected in an enlarged scale on a screen (not shown) by a projection lens 108 having a small aberration, thereby enabling display of the image. At this time, since the diffractive optics and the lens array favorably act as the integrator, the uniformity in the brightness at the time of displaying all white signals of the projected image can be held high over the whole screen. For example, the brightness in the peripheral portion with respect to the brightness in the central portion becomes 80% or higher. The light utilization efficiency of the lamp is also as high as 5 lumen/watt. These figures are values substantially equal to the case of the conventional lighting device that uses two lens arrays, though a part of light is lost as a result of diffraction.

As for the price of the projection type image display device in this embodiment, since it is not necessary to use two lens arrays which is very expensive, the production cost is about 60% of the conventional price.

As a lamp, in this embodiment, for example, an extra-high pressure mercury lamp having a rated power of 120 W is used. However, other lamps such as a metal halide lamp, a halogen lamp, a xenon lamp, a carbon-arc electrode lamp or the like may be used. This applies to other embodiments and other inventions. Moreover, it is generally preferred that the illuminant is smaller, the better in view of efficiency, but it is not always necessary that the illuminant is small, and for example, a high-output xenon lamp or high-output metal halide lamp having an illuminant as large as 5.6 millimeters may be used.

As a reflector used for gathering the output of the lamp, a parabolic mirror, an ellipsoidal mirror, or a spherical mirror may be used. At this time, it is preferred that when the reflector is a parabolic mirror, the illuminant is disposed in the vicinity of a focal point (shown as F in each figure), and when it is an ellipsoidal mirror, the illuminant is disposed in the vicinity of a first focal point (F1), and when it is a spherical mirror, the lamp is disposed in the vicinity of a center of the sphere, in view of condensing light. In this embodiment, for example, a parabolic mirror is used, but when an ellipsoidal mirror is used, a bundle of converging rays is such that the output bundle of light is converged to the second focal point (F2) of the ellipsoidal mirror. Therefore, in this case, as the reference light for exposing the sample for the diffractive optics in Fig. 7(b), the second reference light is not in parallel, and may be a light diverging at an angle substantially equal to the F value of the ellipsoidal mirror from the second focal point.

In this embodiment, as the diffractive optics, a phase-type volume hologram is used, but this may be, for example, a surface relief type volume hologram. At this time, as shown in Fig. 6, the effective area where the bundle of light is illuminated by the diffractive optics is elliptic shape, and hence, rectangular small areas may be intimately arranged inside this area.

At the time of preparing the diffractive optics, a sawtooth wave shape in section is calculated so that the output bundle of light in each small area is substantially converged to each corresponding lens of the lens array, to thereby prepare the diffractive optics by, for example, the electron beam drawing method. The shape of the diffraction grating is not limited to the sawtooth wave shape, and may be a multi-level diffractive element in which the sawtooth wave shape is approximated stepwisely. These can be prepared by a normal semiconductor process, and since mass production is easy, the production cost can be reduced to about one tenth the production cost of the conventional fly eye lens.

As a result, since the cost required for the integrator occupying the most of the cost of the optical system, together with the projection lens can be reduced, even in this case, the production cost of the liquid crystal projector can be suppressed to about 60% of the conventional cost.

When the surface relief type diffractive optics is used, the optical axis of the lamp and the reflector and the normal of the diffractive optics can be made substantially parallel, by changing the sectional shape thereof. In this case, the effective area of the diffractive optics 101 is, for example, circular, and rectangular small areas have only to be formed inside the area.

In this embodiment, the lighting device is applied for a liquid crystal projector using, for example, a transmissive type liquid crystal panel, but it is also possible to use it for various image display elements to give various projection type image display devices.

As the transmissive type liquid crystal panel, there may be used one in which one micro lens is arranged in each pixel, and incident bundle of light is converged to the vicinity of opening of the pixel, to thereby have a function of increasing the effective numerical aperture, as disclosed in, for example, Japanese Unexamined Patent Application Publication Nos. Hei 1-281426, 3-140920, and 4-251221. Needless to say, at the time of application to the present invention, there is no restriction in the optical modulating material, the method of optical modulation and the drive method of pixels.

That is to say, it is possible to use a polarization type image display element using various kinds of liquid crystal materials such as twist nematic liquid crystals (hereinafter, abbreviated as TN liquid crystals), as well as vertical orientated liquid crystals (hereinafter, abbreviated as VA liquid crystals), or optical materials having optical anisotropy such as optical crystals having electro-optic effect. It is also possible to use a decentralized type image display element which displays an image by using not only the polarization type image display element but also a polymer decentralized type liquid crystal (hereinafter, abbreviated as PDLC) to scatter the incident bundle of light. Moreover, it is possible to use a refractive image display element as disclosed in, for example, Japanese Patent Application No. Hei 7-284759, or a so-called optical deflective image display element referred to as DMD element.

Furthermore, as a modified example of the image display device shown in Fig. 5, for example, a color separation optical system comprising a dichroic mirror is arranged between a condenser lens and an image display element such as a transmissive liquid crystal panel, to thereby obtain a full color image display device. At this time, a color synthesis system may be arranged between the image display element and the projection lens. This will be described later.

As described above in detail, according to the present invention, a cheap lighting device can be provided. Also, it is possible to provide a projection type image display device at a price cheaper than before, by using this lighting device. Moreover, by using this lighting device of the present invention, a projection type image display device which is small, compact, and bright having high light utilization efficiency can be obtained.

### (Embodiment of 1-2)

In this embodiment, a polarization transformation element is incorporated in the lighting device of the former embodiment.

When the lighting device of the present invention is used in the projection type image display device using a polarization type liquid crystal panel, it becomes possible to further increase the light utilization efficiency, by combining a polarization transformation element to this lighting device. This will be described below.

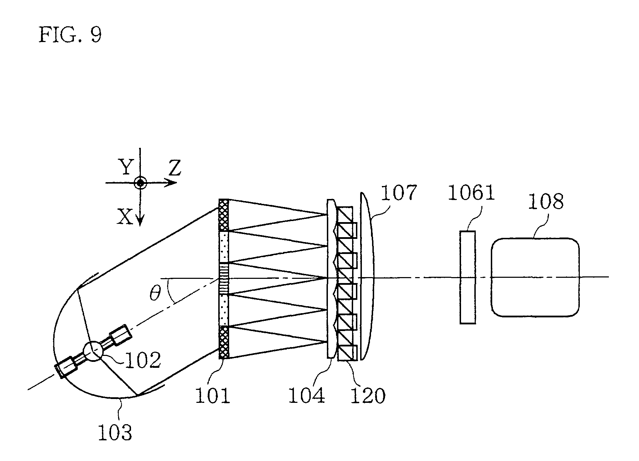

Fig. 9 shows a projection type image display device using a lighting device incorporating this polarization transformation element. The basic construction of this lighting device is similar to that of the lighting device in the former embodiment shown in Fig. 5. However, the different point is that a polarization transformation element 120 is arranged between the lens array 104 and the condenser lens 107. This polarization transformation element may be arranged between the diffractive optics and the lamp, or between the diffractive optics and the lens array, which will be described later in detail.

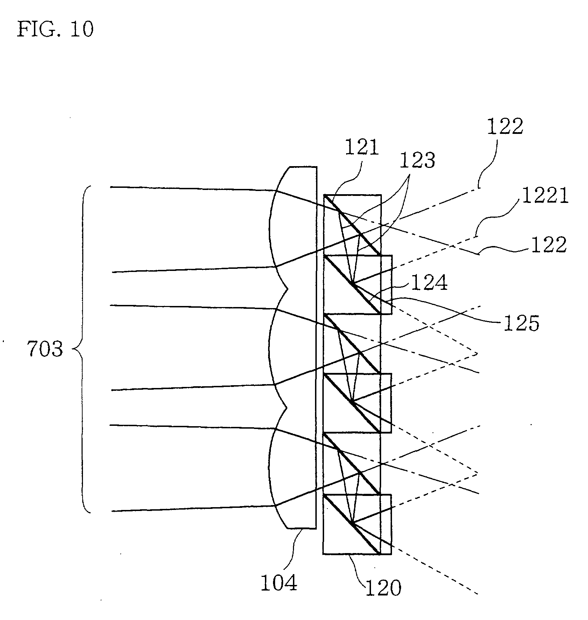

At first, the operation of the polarization transformation element used in this embodiment will be described with reference to Fig. 10.

In the projection type image display device using the polarization type liquid crystal panel, since the polarization component in a specific direction can only be effectively utilized in principle in the output light of the lamp, the projection efficiency becomes low as it is. Accordingly, in order to obtain a bright image, a light source having a large output must be used. The polarization transformation element is developed to solve such a defect, and it effectively utilizes a polarization component which is absorbed by a polarizing plate or reflected by a PBS (push bloom scanner) and does not enter into the liquid crystal panel, by transforming it to a polarization component having a plane of polarization substantially orthogonal with respect to the aforesaid polarization component.

This polarization transformation element is disclosed in many publications, such as Japanese Unexamined Patent Application Publication Nos. Hei 5-107505, 6-202094, 7-294906, 8-234205 and 9-105936, and basically comprising a mixture of polarization separation means and plane of polarization rotation means.

The polarization transformation element 120 shown in Fig. 10 is obtained by joining triangular prisms to give hexahedrons, and adhering the hexahedrons so that the opposite faces form a parallel plate.

On the adhered face of the triangular prisms, there is formed a polarization separation film 121 consisting of a dielectric multiplayer film.

The unpolarized light (a bundle of light of random polarization) 703 output from the diffractive optics 101 and condensed to the fly eye lens 104 is divided into polarization components orthogonal to each other by a polarization separation film, that is, P polarized light (a bundle of light having a polarization direction parallel to the paper, which is transmitted without being reflected by the polarization separation means) 122, and S polarized light (a bundle of light having a polarization direction vertical to the paper, which is reflected by the polarization separation means) 123, and only the S polarized light is reflected by the reflection means 124 (generally using the same kind of film as the polarization separation film), and transformed to the P polarized light 1221 by the means for rotating the plane of polarization 125.

In addition, it is also possible to use a method, as disclosed in, for example, Japanese Unexamined Patent Application Publication Nos. Hei 6-202094 and 8-234205, in which the polarization separation means is disposed on the lamp side of the diffractive optics, and the irradiation angle of the bundle of light after being subjected to the polarization separation is changed by several degrees depending on the polarization component, to thereby change the imaged position on the lens array for each polarization component, and rotation of the plane of polarization is performed only for one polarization component. As an application of this method, it is also possible to have a construction in which a polarization separation element is formed between the diffractive optics and the lens array.

In the projection type image display device in this embodiment, since the integrator is constructed using a cheap diffractive optics instead of a conventional expensive pair of fly eye lenses, the cost can be considerably suppressed. Moreover, since a polarization transformation element is used, light utilization efficiency as high as 8 lumen/watt can be realized.

### (Embodiment 1-3)

In this embodiment, a color separation means is disposed between the diffractive optics and the lamp to enable further efficiency improvement.

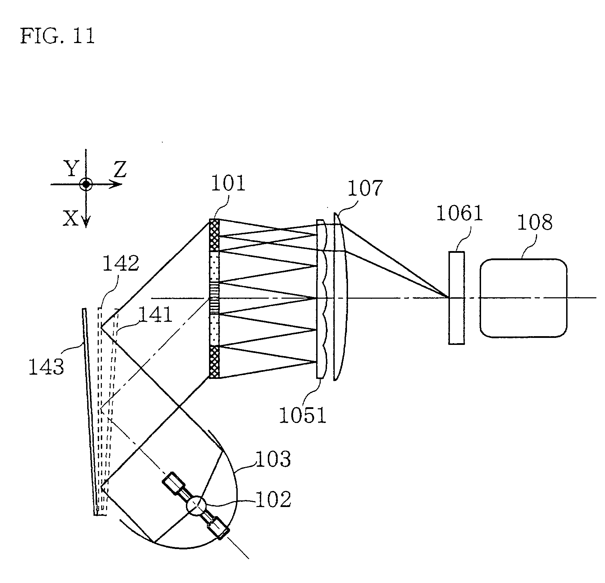

This embodiment will be described with reference to drawings. In this embodiment, as shown in Fig. 11, the angle of the bundle of light from the reflector 103 incident on the diffractive optics 101 is optimized for each three primary color, via dichroic mirrors 141 to 143.

In the diffractive optics using a volume type hologram, if a difference between the incident angle of the reference light and the incident angle of the object light is set, for example, about 30 degrees, the wavelength dependence of the diffraction efficiency with respect to the reconstructed light can be made small. As the incident angle difference increases, the wavelength dependence increases, and when the reconstructed light enters at the same angle as that of the reference light, as the discrepancy between the wavelength of the reference light and the wavelength of the reconstructed light increases, the diffraction efficiency decreases.

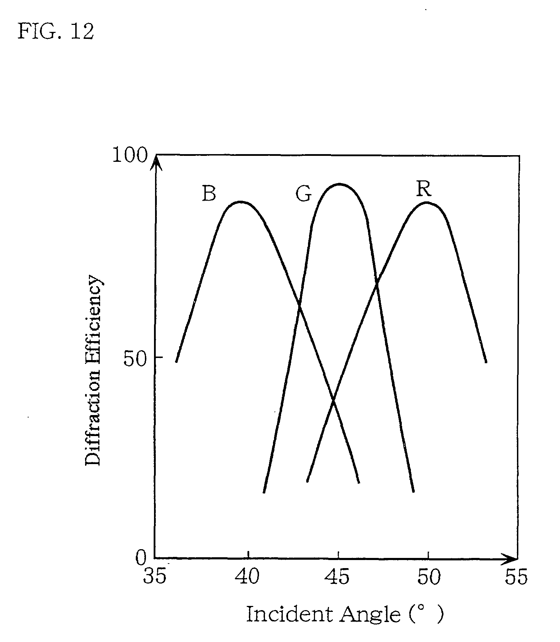

By using the dichroic mirrors, however, even when the wavelength dependency increases (when the incident angle difference between the reference light and the object light is large), high efficiency can be obtained. Fig. 12 shows an example of diffraction efficiency for each primary color of the diffractive optics produced using a laser beam having a wavelength of 514.5 nanometers. In this figure, there is shown the diffraction efficiency when the incident angle of the reference light is 45 degrees, and B (blue) being blue light of 465 nanometers, G (green) being green light of 535 nanometers, and R (red) being red light of 640 nanometers enter as the reconstructed lights.

As seen from this figure, a peak of the diffraction efficiency with respect to the B light and the R light can be seen respectively at a place deviated by 5 degrees on left and right sides in the figure with respect to the G light. Therefore, it is understood that by shifting the incident angle with respect to the diffractive optics having such an angle dependency for each primary color by substantially 5 degrees, the diffraction efficiency of each primary color can be increased to the highest degree with good balance.

In the lighting device shown in Fig. 11, dichroic mirrors 141 to 143 for selectively reflecting each color are arranged respectively at different angles, so that each primary color can enter at the aforesaid optimum incident angle. That is to say, the blue light is incident on the diffractive optics 101 at an angle of substantially 40° by means of the dichroic mirror 141 for reflecting blue color, the green light is incident on the diffractive optics 101 at an angle of substantially 45° by means of the dichroic mirror 142 for reflecting green color, and red light is incident on the diffractive optics 101 at an angle of substantially 50° by means of the dichroic mirror 143 for reflecting red color. As a result, since the three primary colors are diffracted substantially equally and at high efficiency, the light utilization efficiency can be further increased.

The dichroic mirror is sufficiently cheaper than the lens array, and hence, even if three dichroic mirrors are used and combined with the diffractive optics 101, the production cost is as low as one fourth to one fifth the cost of the fly eye lens. That is to say, the lighting device in this embodiment can be produced at a lower production cost than the conventional lighting device. Moreover, as the projection type image display device, since the integrator occupying the most of the cost of the optical system, together with the projection lens can be produced at a low cost, the production cost thereof can be reduced to about 70% of that of the conventional projection type image display device.

### (Embodiment 1-4)

This embodiment is constructed such that in the first embodiment a second diffractive optics is disposed between the reflector and the diffractive optics to thereby form a lighting device more compact.

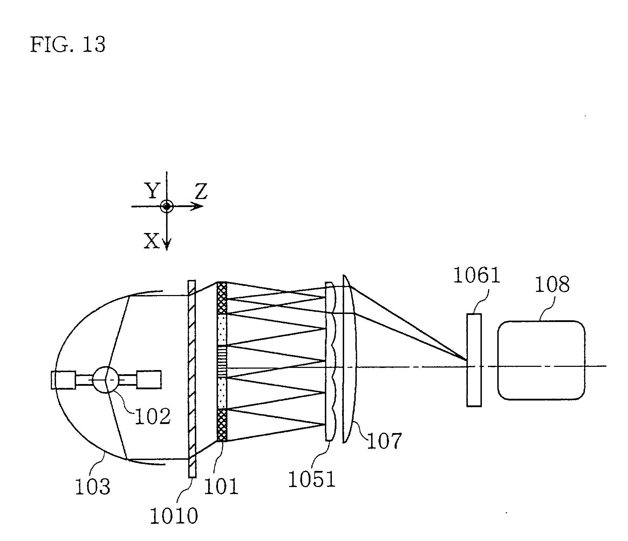

The construction of the lighting device in this embodiment and a projection type image display device using this lighting device is shown in Fig. 13. In this figure, symbol 1010 denotes a second diffractive optics disposed between the reflector 103 and the diffractive optics 101.

As this second diffraction grating, a phase-type volume hologram and a surface relief type diffractive optics may be used as in the diffractive optics 101 existing originally, and in either case, it has a function to output the vertically incident bundle of light at an acute angle with respect to the optical axis.

In this case, because of the reason described above, when a volume hologram is used as the diffractive optics, it is preferred that the incident angle difference between the reference light and the object light be substantially 30 degrees or more. Also, if the object light, that is, the output bundle of light of the first lens array constituting the integrator is substantially in parallel with the normal of the diffractive optics, the focal length of each lens can be made uniform, which is preferable in view of production. Accordingly, to achieve this, the reconstructed light, that is, the output light of the reflector must be incident on the diffractive optics declined by more than 30 degrees. As a result, however, it becomes difficult to bring the reflector and the diffractive optics into intimate contact with each other, and hence the device cannot be made compact. Moreover, since the bundle of light having a circular shape in section is projected, small areas must be arranged in the elliptic effective area of the diffractive optics (see Fig. 6).

On the other hand, with the lighting device in this embodiment, the second diffractive optics outputs the vertically incident bundle of light at an angle of substantially 30 degrees or more so as to enter into the diffractive optics. Therefore, the optical axis of the reflector is made substantially parallel with the normal of the diffractive optics (optical axis of the object light) and arrange the reflector, the second diffractive optics and the diffractive optics in this order intimately to keep the construction compact, while high light utilization efficiency can be obtained.

Moreover, since the second diffractive optics can be produced at a lower cost than the fly eye lens, as with the diffractive optics, the projection type image display device using the lighting device in this embodiment can be produced at a cost 20 to 30% lower than the conventional device.

In the lighting device in the above-described four embodiments, the other fly eye lens may be replaced by the diffractive optics.

Furthermore, a projection aligner, that is, a so-called stepper, which is a device production apparatus of IC, LSI, CCD, liquid crystal panels and magnetic heads can be constructed using the lighting device described in this embodiment. At this time, an optional pattern on an original plate, such as a photomask, or a reticle, which is illuminated by an exposure light from the lighting device according to the invention concerned, is projected and transferred onto a wafer on which a photosensitive agent is coated.

### (Embodiment 1-5)

This embodiment uses a diffractive optics to improve the mirror solid angle rate by utilizing the incident angle dependency of the diffraction.

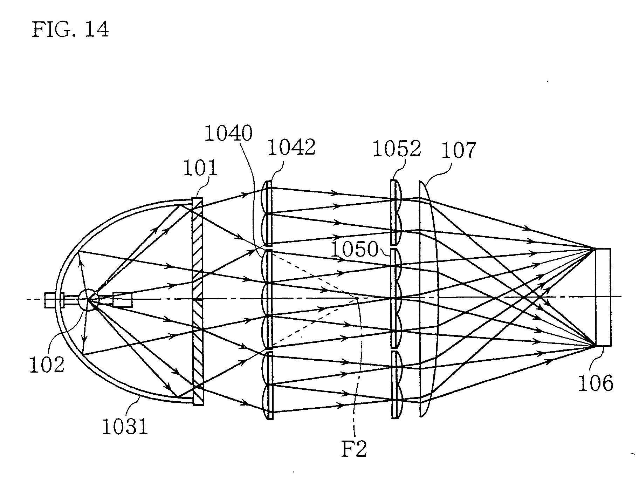

Fig. 14 shows a construction of a lighting device in this embodiment.

In this embodiment, the basic construction is the same as that shown in Fig. 2. However, the different point is that a diffractive optics 104 for condensing light is disposed at an opening on the front face of the ellipsoidal mirror, and two lens arrays respectively consist of circular lenses1040, 1050 having a small diameter on the center side, and concentric toroidal lenses 1042, 1052 on the outer peripheral side.

By arranging the center of the illuminant of the light source 102 in the vicinity of the focal point of the ellipsoidal reflector, the bundle of light reflected by the ellipsoidal reflector 1031 is condensed toward the vicinity of the second focal point (F2), and the incident angle is large, the bundle of light passes through the diffractive optics 101 on the front of the reflector directly, and enters into the fly eye lens 1040 having a small diameter located on the center side disposed on the route of the optical axis.

On the other hand, the bundle of light output directly from the light source to the outside without being reflected enters into the diffractive optics 101 disposed in the vicinity of the reflector opening, and diffracted so as to enter into the lens array 1042 on the outer peripheral side, since the incident angle is large.

The bundle of light incident on the first lens array 1040 on the center side is condensed to the corresponding small lenses of the second lens array 1050 similarly on the center side by the small lenses. Similarly, the light from the lamp which is basically to be unutilized is diffracted by the diffractive optics 101, enters into the first fly eye lens 1042 on the outer peripheral side, and is condensed to the corresponding small lenses in the second lens array 1052 on the outer peripheral side.

The outer peripheral side of the first lens array and the second lens array is arranged so that images of the small lenses of the first lens array and the second lens array on the center side are respectively superimposed on the object to be illuminated 106 via the condenser lens 107.

As is obvious from the above description, in this embodiment, the lens array on the center side works as a first integrator, and the lens array on the outer peripheral side works as a second integrator, thereby the reflected light reflected by the reflector and the diffracted light by means of the diffractive optics are respectively independently condensed to thereby illuminate the object to be illuminated.

In the case of a combination of conventional reflective mirrors shown in Fig. 3,the inner diameter of the spherical mirror must be made larger than the outer diameter of the condensed bundle of light 115, in order that the reflected light of the reflector is not eclipsed by the spherical mirror 113. Therefore, it is actually impossible to set the mirror solid angle rate close to 100%.

With the lighting device in this embodiment, however, even if the reflected light of the ellipsoidal mirror enters into the diffractive optics, the most of the bundle of light is not diffracted, and condensed to the first lens array on the center side. That is to say, the diffraction efficiency of the diffractive optics is different depending on the incident angle (having an angular selectivity), and hence the reflected bundle of light from the reflector is hardly diffracted and progresses directly. On the other hand, only the direct light from the light source is selectively diffracted, since it has an incident angle as large as 30 degrees.

Accordingly, it becomes possible to cover all the opening portion of the reflector with the diffractive optics so that the reflected light is made to progress as it is, and the direct light which is diverged and cannot be used heretofore can be utilized by being refracted by diffraction. As a result, the condensing efficiency can be considerably improved.

Moreover, with the conventional lighting device, the spherical mirror is formed in a glass ball having a thickness of 5.6 millimeters, from the necessity to precisely keep the spherical shape even if it is exposed to a strong light, and hence it is expensive. On the contrary, the diffractive optics used in the lighting device of the present invention is cheap and is also easily producible.

As the diffractive optics used for improving the mirror solid angle rate of this reflector, a so-called hologram can be used, as with the diffractive optics used for improvement on the integrator side. This hologram is produced by recording desired interference fringes on a hologram material by means of two-beam interference exposure. As the hologram material, the above-described materials may be used. In this embodiment, for example, a photopolymer (manufactured by DuPont Co.) is used, to produce a phase-type volume hologram in which the diffraction efficiency becomes highest.

The production method of the diffractive optics used in this embodiment is basically the same as those of the first to the fourth embodiments described above.

The function of the hologram used as the diffractive optics in this embodiment is to output a bundle of light incident on the second lens array on the outer peripheral side as a reconstructed object light, using the reconstructed light as the output bundle of light of the light source.

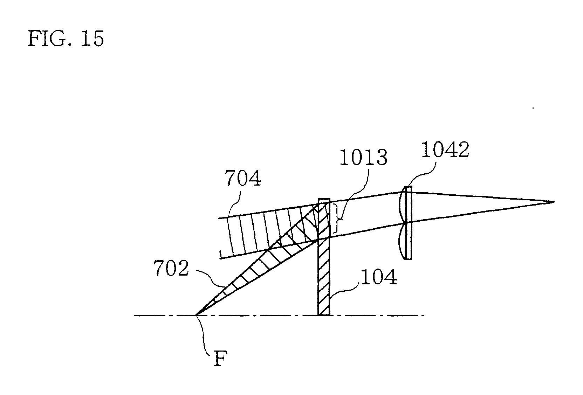

Fig. 15 shows a relation between the reference light 702 and the object light 704 irradiated when a specific area 1013 of the diffractive optics used in this embodiment is produced.

This specific area is a hologram on which a spherical wave diverging from the focal point F of the elliptic reflector 1031 is designated as the reference light 704, and a plane wave passing through the specific area and incident on the second lens array 1042 on the outer peripheral side is designated as the object light, and these interference fringes are recorded.

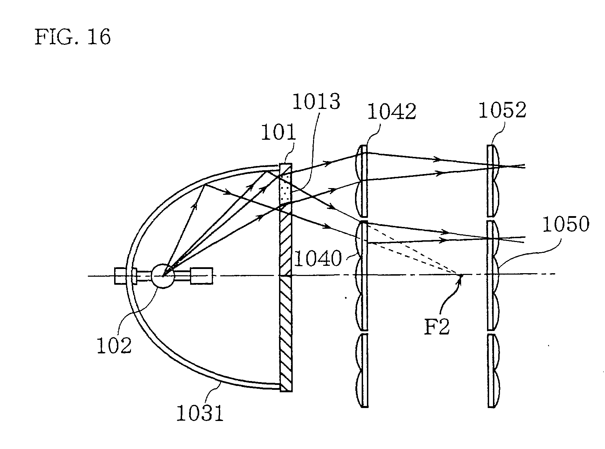

When the output bundle of light from the light source 102 enters as the reconstructed light 702 into the specific area prepared by recording these interference fringes, as shown in Fig. 16, the incident bundle of light is diffracted in the direction of the recorded object light, and led to the first lens array on the outer peripheral side. The bundle of light incident on this lens array then effectively illuminates the object to be illuminated via the second lens array and the condenser lens.

The bundle of light reflected by the reflector also enters into this specific area, but if the angle θ between the reflected bundle of light and the object light is sufficiently large, the reflected bundle of light is hardly diffracted due to the angular selectivity of the hologram, and enters into the first lens array on the center side. Accordingly, even if the diffractive optics is arranged so as to cover the whole face of the opening of the reflector, it is possible to favorably separate the reflected light from the ellipsoidal mirror and the direct light from the illuminant of the light source and guide these to the area to be illuminated respectively. As a result, the mirror solid angle rate becomes considerably high.

This diffractive optics may be prepared by being divided into a plurality of areas. That is to say, the object light has only to be a bundle of light passing through the diffractive optics and incident on the first fly eye lens on the outer peripheral side, and hence the object light may be changed for each specific area. Moreover, each portion of the specific area and each small lens of the first fly eye lens on the outer peripheral side may be one-to-one correspondence.

It is not always necessary to prepare the diffractive optics so as to cover the whole face of the opening of the ellipsoidal mirror.

Furthermore, the diffractive optics may not be produced directly as a single object, but may be produced, according to a case, in such a manner that a so-called fan shaped small elements are produced and these are joined together to form a doughnut-shape diffractive optics.

The bundle of light output substantially in parallel with the optical axis or in a shallow angle directly from the light source is eclipsed by a vessel covering the illuminant of the light source or a mouthpiece supporting the electrode and hardly output. Moreover, since angle between the light reflected by the elliptic reflector, then passing through a route close to the optical axis in the vicinity of the opening center and condensed to the second focal point and the direct light from the illuminant is small, there is a possibility that a part of the reflected bundle of light which is to be directed to the direction of the second focal point is diffracted. Hence, it is not always necessary to have a diffraction function in the vicinity of the optical axis. In this case, if the diffracted bundle of light enters into the first lens array on the outer peripheral side, and guided to the area to be illuminated via the second lens array and the condenser lens, there is almost no change in the efficiency. Accordingly, it is not necessary to dare to diffract the direct bundle of light in the vicinity of the optical axis, and even if the direct bundle of light is diffracted, there is almost no change in the efficiency.

Moreover, it is not always necessary to arrange the first lens array and the second lens array on the center side and on the outer peripheral side continuously on the same plane vertical to the optical axis, and these may be arranged separately on the same plane or on a different plane.

Furthermore, when the lighting optical device in this embodiment is used in a projection display, the external shape of each small lens of the first lens array and the second lens array on the center side can be made substantially similar to the opening shape of an image display element (for example, a liquid crystal panel) which is an object to be illuminated, so that the output of each small lens of the first lens array and the second lens array is superimposed on the object to be illuminated. In this case, as mentioned in the description of Fig. 2, a dichroic mirror or a relay lens for color separation may be used.

As disclosed in, for example, Japanese Unexamined Patent Application Publication No. Hei 5-346557, by properly deviating the optical axis of each lens, the external shape of the first lens array and the second lens array on the outer peripheral side can be made small, or the condenser lens may be omitted.

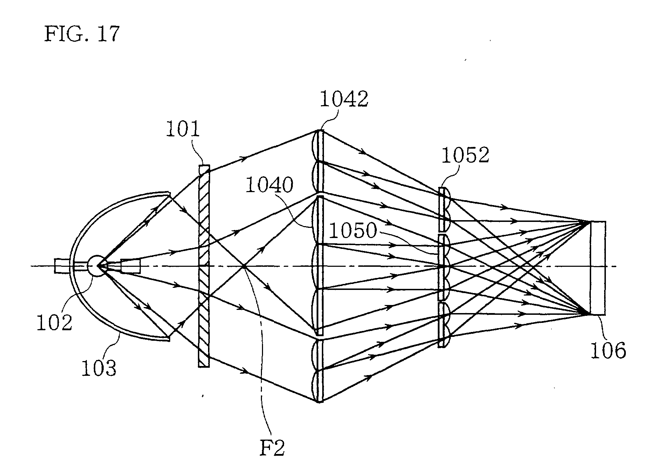

Moreover, as a place where the first lens array on the center side and the outer peripheral side is disposed, it may be a point towards the area to be illuminated than the second focal point. Fig. 17 shows one example in this case. Furthermore, the construction may be such that the external shape of the first lens array on the center side is substantially the same as the size of the ellipsoidal mirror, and the first fly eye lens on the outer peripheral side is arranged on the periphery thereof.

### (Embodiment 1-6)

In this embodiment, the lighting device in the former embodiment is combined with a polarization transformation element, for being used in a lighting optical system of a liquid crystal projection display.

The polarization transformation element comprises generally a polarization separation element and plane of polarization rotation means. Unporalized bundle of light incident by the polarization separation element is separated into bundles of light whose plane of polarization is orthogonal to each other, and one plane of polarization is rotated by substantially 90 degrees and output by the plane of polarization rotation means, to be transformed into substantially linearly polarized light, thereby improving the light utilization efficiency of the liquid crystal projection display which originally utilizes polarization for control of transmission (shades) of light.

When the polarization transformation element is combined, there are three points as a place to arrange the polarization separation means, that is, on the light source side than the first lens array, between the first lens array and the second lens array, and on the side of the object to be illuminated of the second fly eye lens.

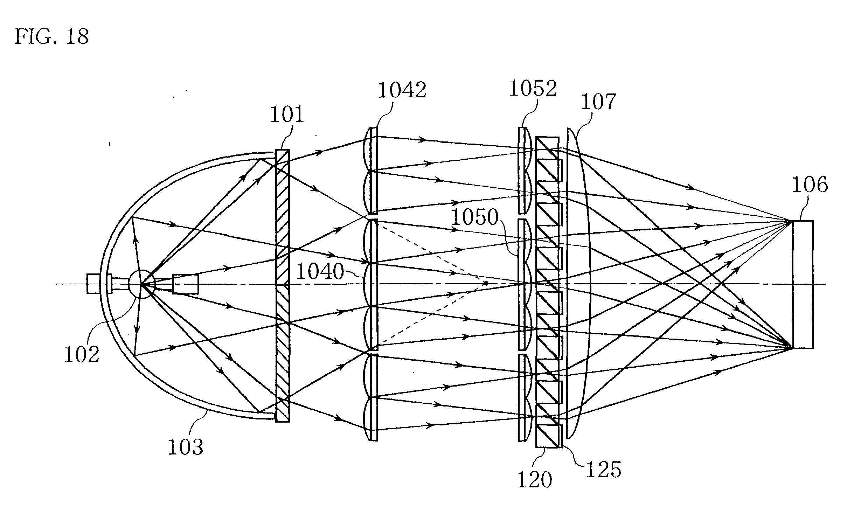

This embodiment is the third case described above. Fig. 18 shows a configuration of a lighting device in this embodiment. As is clearly shown in this figure, the polarization transformation element comprises a polarization separation element 120 and plane of polarization rotation means 125.

The polarization transformation element 120 is one using a PBS (polarization beam splitter) array, as disclosed in, for example, SID 97 DIGEST pp. 993-996. That is to say, the polarization transformation element 120 is obtained by joining triangular prisms to give hexahedrons, and adhering the hexahedrons. On the adhered face of the prisms, there is formed a polarization separation film consisting of a dielectric multiplayer film. As the plane of polarization rotation means, a so-called 1/2 wave plate may be used.

In this embodiment, the polarization transformation element is the same as that of the second embodiment. In the lighting device constructed in this manner, the bundle of light condensed by the first fly eye lens enters into the polarization separation element and is separated to P polarized light and S polarized light, and either one is output with the plane of polarization being rotated substantially by 90 degrees. Hence, the light incident on the liquid crystal panel 106 becomes linearly polarized light. As a result, there is almost no absorption by means of the polarizing plate (not shown) disposed on the incident side of the liquid crystal panel, thereby further increasing the light utilization efficiency.

Here, as the polarization separation element, the PBS array is used, but other means by means of original title may be applied.

Moreover, a projection aligner, that is, a so-called stepper, which is a device production apparatus of IC, LSI, CCD, liquid crystal panels and magnetic heads can be constructed using the lighting device in this invention group. At this time, an optional pattern on an original plate, such as a photomask, or a reticle, which is illuminated by an exposure light from the lighting device according to the present invention, is projected and transferred onto a wafer on which a photosensitive agent is coated.

### [Second Group of Aspect of the Invention]

### (Embodiment of 2-1)

This embodiment combines a scattering anisotropic screen and a hologram, to improve color reproduction.

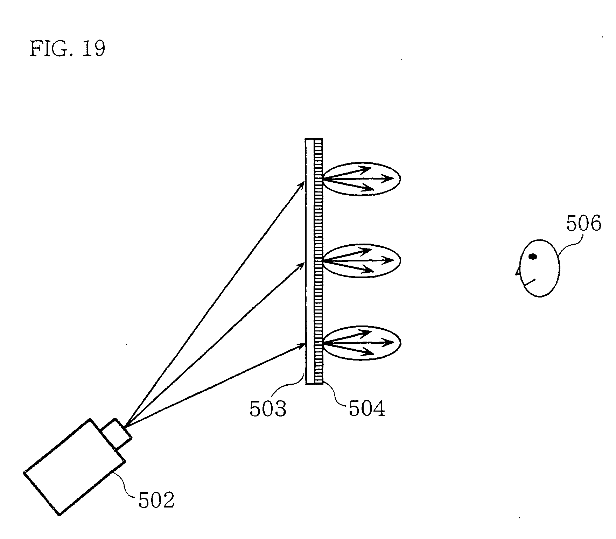

Fig. 19 shows a situation where the effect of the image display device in this embodiment is exerted. The bundle of light of the image from a projection type image display means 502 is projected to a scattering anisotropic screen (since it is bothersome to write "scattering anisotropic screen" in detail and there is no possibility of misunderstanding, hereinafter referred to as a "scattering screen") 503. This screen having the scattering anisotropy has a function of scattering and transmitting the bundle of light incident from a specific angle range (hereinafter referred to as "scattering angle range"), and on the other hand, directly transmitting the incident light from ranges other than the scattering angle range. Specifically, a material consisting of a light control film having such a function (for example, product name: Lumisty, manufactured by Sumitomo Chemical Co. Ltd.) is adhered on, for example, a transparent glass substrate to thereby produce this screen.

The bundle of light of this scattered image is conventionally brightest in the projected direction (right oblique upper direction in the figure). Therefore, a thin Fresnel lens (diffraction lens) 504 is arranged on the observer 506 side of the scattering screen. At this time, by positioning the Fresnel lens such that the focal point of the Fresnel lens is substantially located close to the lens of the projection type image display means, thereby enabling directing the scattered light toward the observer. As a result, the image is made brighter. Also at this time, since the scattering screen has a small wavelength-selectivity, the color of the projected image can be displayed with fidelity, enabling display of an image excellent in color reproduction.

As the projection type image display means, there can be used a normal liquid crystal projector, a DLP projector using an optical deflection type image display element as disclosed in U.S. Patent No. 5,096,279, a CRT projector, a laser scanning type image display means or the like, however, it is more preferable to use the ones in each embodiment of the first invention group described above. When the liquid crystal projector is used, since a trapezoidal correction may occur, the signal may be converted to remove the trapezoidal distortion.

It is not always necessary that the scattering screen and the optical deflection means have the same size and the same shape as that of the projected image. For example, if it is assumed that the external shape of the scattering screen is for example heartshaped, only an image obtained by cutting out the projected image by the heart is scattered, and deflected in the direction of normal. As a result, a picture having a heartshaped external shape (profile) is displayed on the transparent screen. This applies to the Fresnel lens, being the optical deflection means. Small pieces in the same shape may also be arranged in a plurality of numbers to thereby form a scattering screen or optical deflection means.

Moreover, according to the situation, it is preferable to perform adequate processing such as forming a reflection prevention film or the like on the side away from the observer of the scattering screen, so that the scattered light is not directed [toward the observer] as much as possible.

Though it applies to all embodiments described below, when the scattering screen, the optical deflection means and the transparent member are stuck and adhered together, it is desired to form a reflection protection film on an interface contact with the air in order to suppress unnecessary reflection on the interface as much as possible, and to use an adhesive having substantially equal refractive index as each member and transmittance, for adhering different kind of interfaces.

Furthermore, as the transparent member on which the scattering screen and the optical deflection means are disposed, there can be used materials having light transmissive function, for example, every possible glasses such as show window, window glass of buildings, windshields, side glasses and rear glasses of transportation means such as vehicles, trains, aircrafts and ships, plastics, and various kinds of resins. It is not always necessary that the transparent member is transparent on the whole face, and only a part where the image is displayed may be transparent.

### (Embodiment 2-2)

This embodiment is for improving the arrangement of the Fresnel lens in the former embodiment.

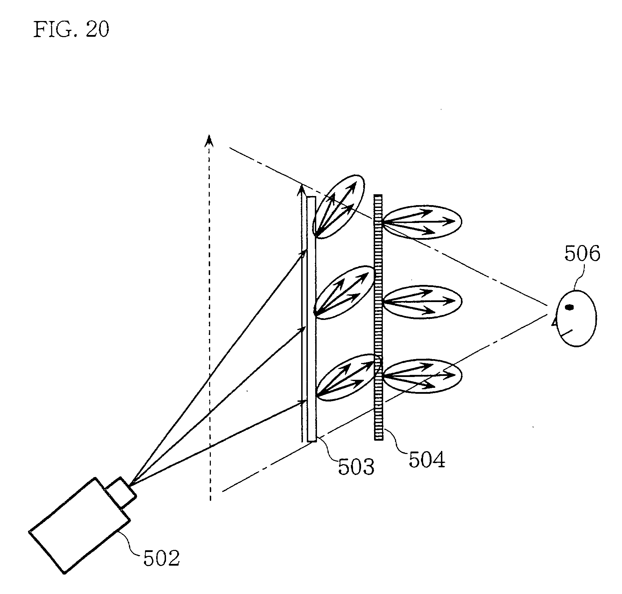

Fig. 20 shows a construction of an image display device in another embodiment of the present invention. In this embodiment, the Fresnel lens 504 is arranged apart from the scattering screen 505, and hence the image displayed on the scattering screen shown by an arrow of a solid line is enlarged as shown by a broken line with an arrow in the vertical direction, and the image is displayed brighter in the perpendicular direction of the scattering screen. This is because the Fresnel lens deflects the light scattered in the right obliquely upper direction to the perpendicular direction, and displays an enlarged virtual image to the observer. Therefore, the Fresnel lens can display an image not only simply bright but also large.

Needless to say, in this case, the distance between the Fresnel lens and the scattering screen is less than the focal length of the Fresnel lens.

Moreover, it is a principle that the scattering screen is adhered on an unillustrated glass plate (such as a show window glass). According to the case, the Fresnel lens may be similarly adhered onto the glass plate.

### (Embodiment 2-3)

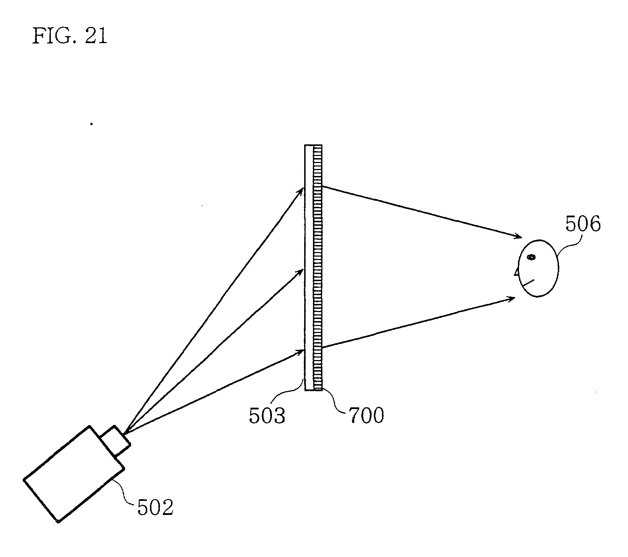

Fig. 21 shows a construction of an image display device in this embodiment. As in the embodiment 2-1, the projection type image display means 502 projects an image onto a scattering screen 503 having a selective scattering anisotropy. At this time, the incident (projection) angle is within a scattering angle range of the scattering screen.

Here, the incident angle is an angle between a segment connecting the light output section of the image display means (for example, a projection lens of a liquid crystal projector) and each point on the scattering screen and the normal of the scattering screen, and the scattering angle range is an angle range where the scattering screen scatters and transmits the incident light.

This scattering screen scatters the bundle of light of a projected image. If a hologram 700 is not used, the point that the brightest image is observed is in the incident direction of the light, and as it is, the observer has to observe the image from the upper position.

However, with the image display device in this embodiment, the hologram has an effect of diffracting and deflecting the light, while condensing light in the direction of the observer, as with the Fresnel lens. Therefore, the brightest image can be observed in the direction of normal of the scattering screen 503. Moreover, since not a simple transmitted light but a pre-scattered light (that is, light scattered in a certain angle range) is incident on the hologram, the image is deflected not only in the direction of normal, but also in the vertical and horizontal directions within a predetermined angle range. As a result, the visually recognizable range of the image can be enlarged.

If it is desired to show the brightest image to the observer standing in a position further away from the hologram, a parallel light or gentle converging rays close to the parallel light may be used. These are a designing matter option, and may be changed depending on a position at which the brightest image is observed.

The construction is such that the scattering screen transmits the incident light in the vicinity of the normal direction (for example, about ± 10 to 20°) without scattering. This means that the vicinity of the normal direction is outside the scattering angle range. Therefore, when an image is not output from the projection type image display means, the observer can favorably observe the inside situation.

Moreover, when a hologram prepared by the interference exposure described below is used, it is a matter of course that the hologram is arranged so that the incident angle of the reference light at the time of preparation thereof is substantially the same as the incident angle of the image projected on the scattering screen and comes into the scattering angle range of the scattering screen, and the incident angle of the object light is outside the scattering angle range of the scattering screen.

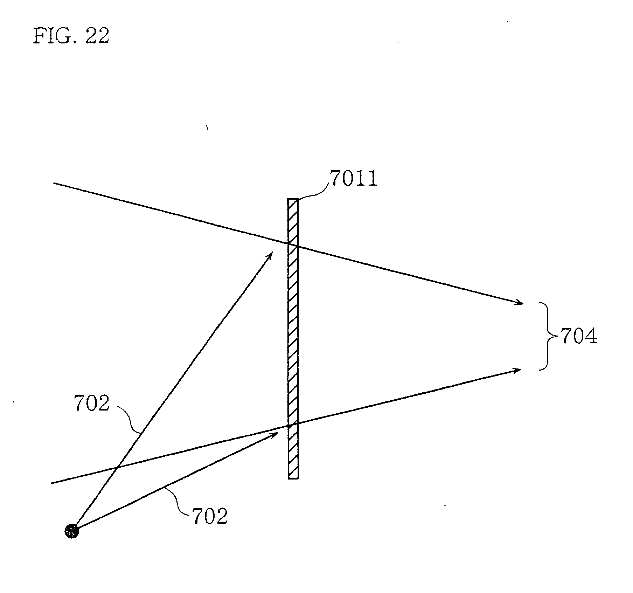

This hologram is prepared, for example, as shown in Fig. 22, by recording interference fringes formed by the laser beams 702, 704 capable of interfering with each other (normally, formed by separating the laser beam) on a hologram recording material 701.

As the hologram recording material, the same materials as in the first invention group may be used.

In addition, such a hologram may be used that is prepared by forming interference fringes obtained by calculation simulation on a photoresist by means of the electron beam drawing method, which is a known technique. That is to say, it is possible to use all of the diffractive optics, in the wide sense, having an optical deflection function. However, in this embodiment, a refractive index distribution type volume hologram is used in which the diffraction efficiency becomes highest, by using a photopolymer (manufactured by DuPont Co.). In this case, as the reference light 702, a bundle of light incident at a substantially same angle as the bundle of light incident on the scattering screen from the projection type image display device may be used. Also, the object light 704 may have an angle that substantially coincides with the viewing range (a range where it is desired to display the image bright and favorably).

It is not always necessary to produce this hologram as a single large element, and a plurality of small elements may be connected to produce this hologram.

If it is described here to make sure, the hologram in this embodiment does not always require a scattering function for enlarging the viewing range, different from the conventional hologram screen, and used in combination with a screen having a scattering anisotropy. That is to say, scattering means is separately added in addition to the hologram.

With the conventional hologram screen, it is necessary that the hologram screen itself has a function of scattering anisotropy (function of distributing light into a specific viewing range), in order to widen the viewing range (angle of visibility). Therefore, as disclosed in, for example, Fig. 3 of Japanese Unexamined Patent Application Publication No. Hei 9-33856, it is necessary to use scattered light as the object light. Here, the scattered light means not only a so-called fully scattered light, but also in the wide sense, a light distributed into a specific solid angle.

With the image display device in this embodiment, however, after the projected image is once scattered by the scattering screen, the direction of the image is changed towards the observer by the hologram. That is to say, the scattering function for widening the viewing range and the deflection function for directing the light towards the observer are provided separately. As a result, more favorable color reproduction and uniformity can be realized compared to the conventional hologram screen. That is to say, if the scattering function is carried by only the hologram, as shown in Fig. 4(a), the hologram is strongly affected by the wavelength dependence, to thereby decrease the diffraction efficiency itself, resulting in enlargement of light in an unnecessarily wide range.

Moreover, it is not necessary to give a strong scattering performance to the hologram, and from this viewpoint, this hologram can be produced at a lower cost than the conventional hologram screen.

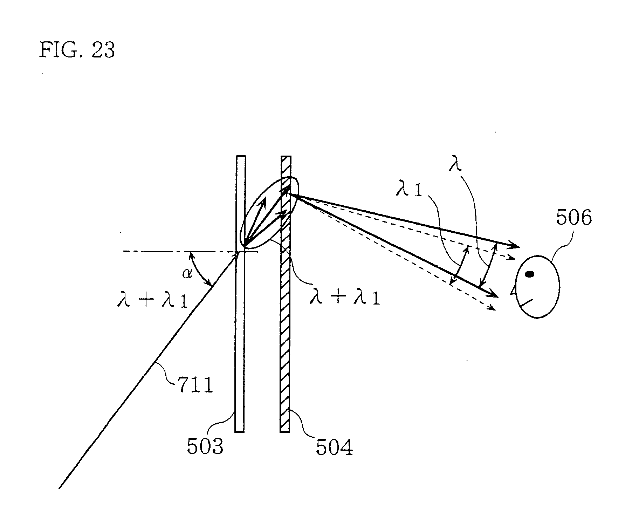

The reason why favorable color reproduction can be obtained by dividing these functions will now be described, with reference to Fig. 23. In this figure, from the convenience sake of explanation, there is a gap between the scattering screen 503 and the hologram 504, but it is desired that they are brought into intimate contact with each other.

With the image display device in this embodiment, when the incident light enters from the scattering angle range of the scattering screen 503, the incident light is scattered by the scattering screen. At this time, it has the brightest luminance distribution substantially in the incident direction. The hologram has a function of deflecting this incident angle towards the observer 506. At this time, the hologram not only diffracts the light in the direction of the object light at the time of production, but also can scatter the light within a certain specific angle. Because the incident angle is scattered in advance by the scattering screen. Approximately, when the incident angle is scattered in the range of ±Δθ, even if the hologram does not have the scattering function, the deflected light is spreadable about ±Δθ. If the hologram itself has a scattering function of about ±Δθ, light is further spreadable, and expanded to about ± (Δθ+Δθ'). Even if the hologram itself does not have a strong scattering function, the viewing range can be made wide.

Moreover, the favorable color reproduction can be ensured. The reason will now be described schematically. It will be described in more detail in the embodiment described later.

It is assumed that the hologram is prepared by interference exposure of a wavelength λ, and the incident angle α is substantially equal to the incident angle of the projected image. When a light having a wavelength λ and a light having a wavelength λ1 different therefrom enter into the scattering screen at an angle α, λ and λ1 are scattered in almost the same direction at substantially the same efficiency, since the scattering function of the scattering screen does not depend on the wavelength.

The light having the wavelength λ and the light having the wavelength λ1 incident on the hologram at an angle a is respectively diffracted to a different angle, due to the wavelength dependence. However, in this embodiment, since the incident light of the hologram is scattered in advance, it means for the hologram that light having a certain angular distribution enters into one point. That is to say, all the incident wavelengths enter into one point on the hologram with a certain angular distribution. Accordingly, since a component strongly diffracted towards the image observer exists in each wavelength, an image having a wide visually recognizable range of image and favorable color reproduction can be displayed.

For example, this figure shows a case of λ1>λ, but at this time, λ1 is deflected at a larger angle than λ. Therefore, the light having the wavelength λ1 directed to the eyes of the observer is a component incident at an angle α1 (>α) larger than the incident angle of a light having the wavelength λ directed to the eyes of the observer (in this case, α). Since the light having the wavelength λ is incident at an angle α at the time of production, it is diffracted towards the observer at high efficiency. Though the diffraction efficiency of the light having the wavelength λ1 incident at an angle α is low, the diffraction efficiency of the light having the wavelength λ1 incident at an angle α1 (>α) becomes, as is well known, higher than that of when the light having the wavelength λ1 enters at an angle α. Accordingly, since light enters towards the observer at high efficiency for both λ and λ1, the color reproduction is excellent. This applies to a case of other wavelength λ2 (λ2<λ).

In this manner, by making the light scattered in advance enter into the hologram, all colors can be deflected towards the image observer at high efficiency, thereby realizing excellent color reproduction. Also with this hologram, multiple exposure is not necessary, thereby enabling easy production at a low cost.

Needless to say, the hologram may have the scattering function. In this case, it becomes possible to considerably widen the viewing range, in addition to the excellence in color reproduction of the display image. That is to say, it is assumed that the main wavelength is for example 514.5 nanometers. When the light enters at the same angle, the diffraction angle is distributed in a range of about ± 7 degrees depending on the wavelength in the whole visible range. This means that if the scattered light of more than ± 7 degrees enters, on the contrary, the wavelength in the whole visible range has a diffraction component in the direction of the main wavelength λ being diffracted. Therefore, by combining the scattering screen and the hologram, the viewing range having excellent color reproduction can be enlarged.

If it is described here to make sure, it is a matter of course that when an image is not displayed, the transmitted image can be favorably observed.

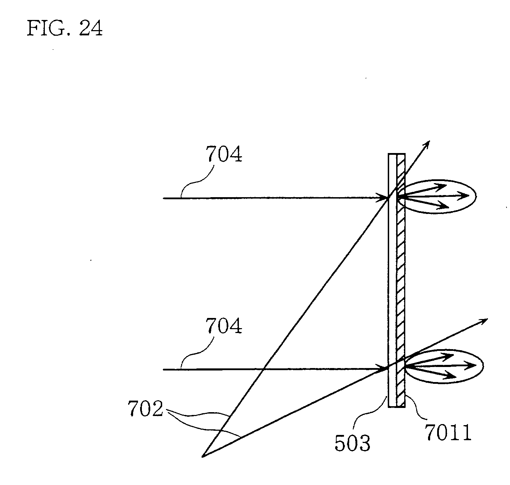

Though some explanation may be doubled, since it is connected directly to the gist of the present invention, preparation of the hologram in this embodiment will be described with reference to Fig. 24.

A hologram recording material 7011 consisting of a photopolymer laminated on a glass substrate and a scattering screen 503 are arranged in intimate contact with each other. The reference light 702 is projected from a direction substantially the same with the direction that the image enters from the projection type image display means. The object light 704 is projected from a direction substantially perpendicular to the hologram recording material.

At this time, the scattering screen has a function of selectively scattering only a light incident from the vicinity of the perpendicular direction (for example, about ± 10 to 20°). Therefore, the reference light enters into the hologram recording material without being scattered, while the object light is scattered by the scattering screen and enters into the hologram recording material. Then, the interference fringes of these two bundles of light are recorded on the hologram recording material. In this manner, a hologram having a scattering function can be produced considerably easily.

For example, the object light may be made to enter via a Fresnel lens having a long focal point. That is to say, for example, when the object light is assumed to be converging rays, bright display having excellent color reproduction becomes possible, though the viewing range becomes slightly narrow. Moreover, by adjusting the expansion of the object light by designating the object light as adequate diverging rays, the viewing range can be further enlarged.

### (Embodiment 2-4)

In this embodiment, a scattering screen and an optical deflection means are disposed on a reflection member.

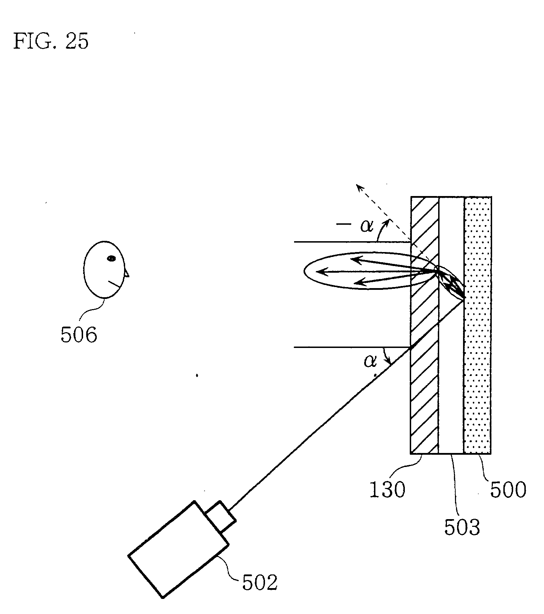

The construction of an image display device in this embodiment is shown in Fig. 25. As is clearly seen from this figure, this image display device is constructed such that the optical deflection means 130 and the scattering screen 503 are arranged in intimate contact with the reflection member 500 from the left in the figure in this order. The output light of projection type image display means 502 forms an image on the scattering screen via the optical deflection means. At this time, the optical deflection means has angle dependence such that it deflects the bundle of light incident in the vicinity of an angle -α substantially to the direction of normal, but directly transmits the bundle of light directly enters at an angle α. Also, the scattering screen scatters the bundle of light incident from the vicinity of at least either one of the incident angle α or -α.

When the angle α is within the scattering angle range, the image transmitted through the optical deflection means is scattered on the scattering screen, and thereafter reflected by the reflection member. Therefore, the reflected light passes again through the scattering screen, and enters into the optical deflection means as a bundle of light scattered in a certain angle range, centering on the angle -α.

When the angle -α is within the scattering angle range, the light incident on the scattering screen at an angle α is reflected by the reflection member, and is scattered when again entering into the scattering screen in the vicinity of the angle -α.

When both angles of α and -α are within the scattering angle range, the light is subjected to the scattering operation twice when directly entering the scattering screen and when being reflected by the reflection member and then passing through the scattering screen, and enters into the optical deflection means. In either case, a bundle of light in the vicinity of the incident angle -α enters into the optical deflection means, and the optical deflection means has a function of deflecting the incident light to the vicinity of the direction of normal.

By means of the above operation, the projected image is observed by an observer 506. When an image is not projected, the image display device serves as a mirror in this construction. Therefore, for example, by alternately repeating image display and non-display, it becomes possible to switch image display and mirror alternately, thereby enabling use as an advertising medium attracting customers.

Moreover, the image display device in this embodiment can display an image having a wide visually recognizable range of image and favorable color reproduction, as with the image display device described in the former embodiment.

Furthermore, for example, if a half mirror is used as the reflection member, an advertising effect can be further exerted, by freely switching the image and a situation over the half mirror.

As the optical deflection means, a hologram prepared by two-beam interference exposure is used in this embodiment, but it is a matter of course that other diffractive optics may be used.

Though considerably overlapping, a production method of a hologram used in this embodiment together with the reflection member will now be described.

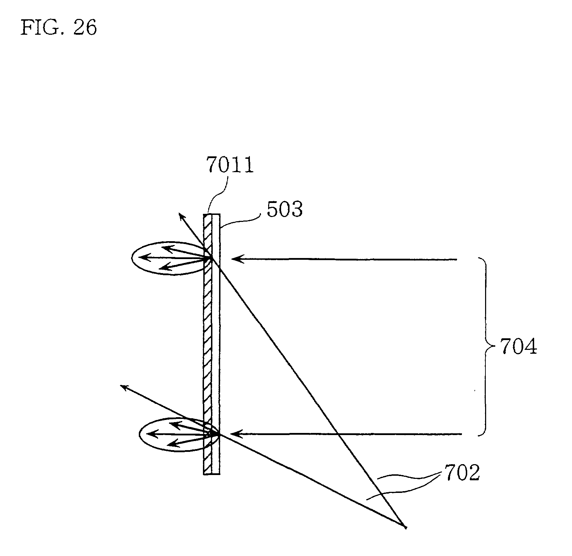

As shown in Fig. 26, interference fringes formed by exposing coherent two beams on a system in which a scattering screen 503 is stuck to and arranged on a hologram recording material 7011, as the reference light 702 and the object light 704, are recorded on the hologram recording material. At this time, the reference light is made to enter at an incident angle outside the scattering angle range of the scattering screen. Therefore, the reference light enters into the hologram recording material without being scattered. This incident angle is an angle substantially equal to the angle that the image reflected by the reflection member in the image display device enters into the hologram, that is, equal to the angle -α in the former construction shown in Fig. 25.

On the other hand, the object light enters into the scattering screen within the scattering angle range, and is scattered and enters into the hologram recording material. In this embodiment, the incident angle of the object light is substantially a parallel-light, entering in the direction of normal, but this may be determined according to the visually recognizable range of the image to be added as a function of the image display device, and either of converging rays or diverging rays may be used. That is to say, if converging rays are used, though the visually recognizable range of the image becomes narrow, a bright image can be displayed with respect to the image observer. On the other hand, if diverging rays are used, though the image becomes dark, the visually recognizable range of the image can be enlarged. Therefore, optimum rays are selected properly according to the application and the installed place.

### (Embodiment 2-5)

This embodiment relates to a light control device used for a liquid crystal display device, hologram pictures in a show window or the like.

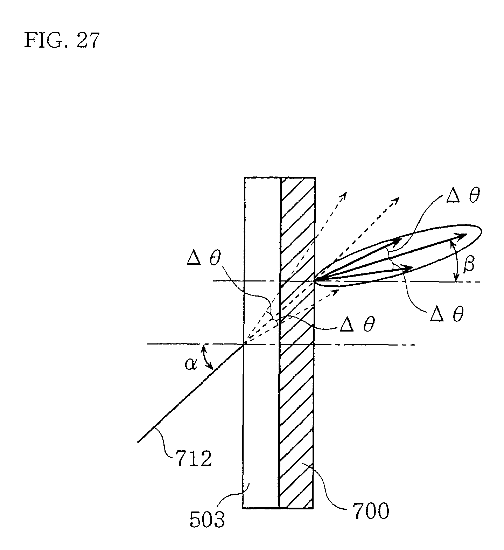

Fig. 27 shows a construction of the light control device in this embodiment. In this figure, symbol 501 denotes a scattering screen, and 702 denotes a hologram. Also, 712 denotes a white external light.

The scattering screen and the hologram are stuck together, as shown in the figure, to thereby constitute the light control device.

The principle, operation or the like of this light control device will be described.

As the reference light at the time of producing the hologram in this embodiment, a substantially parallel light of an incident angle α is used, and a substantially parallel light of an incident angle β is used as the object light. The incident angle of the reference light is within the scattering angle range of the scattering screen (α ± △α).

The white external light 712 incident on this light control device at an angle α becomes a scattered light which is distributed in a certain specific angle range, for example, in the range of α ± △θ, and enters into the hologram on the back side. This hologram has a property of deflecting the incident light to an angle range of about β ± △θ and outputting the light. The light output at this angle β is closer to the white color, compared to the white external light transmitted through the light control device consisting of only a hologram.

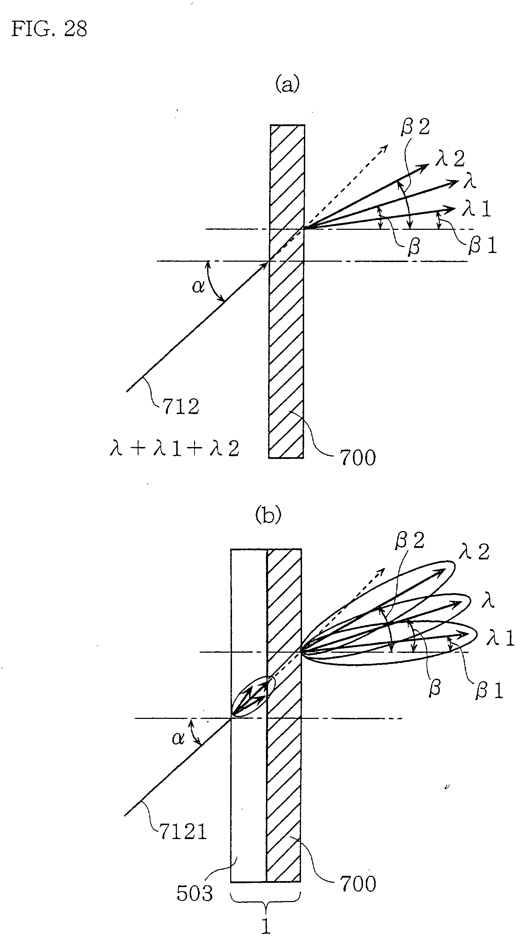

Though some parts are overlapping on the schematic explanation in the embodiment (2-3), but this will be described in detail. Fig. 28 is a diagram for explaining a difference between a case where only a conventional hologram is used, and a light control device in this embodiment. In this figure, (a) is a light control device using only a hologram, and (b) is a light control device in this embodiment. As shown in (a), it is assumed that an external light 712 having a wavelength λ, λ1 and λ2 (λ1>λ>λ2) enters into the hologram from an angle α. Here, the wavelength λ is a wavelength of a light used for producing the hologram. At this time, the light of the wavelength λ is output at an angle β, but the light of the wavelength λ1 and λ2 are output at a different angle, β1 (<β) and β2 (>β), depending on the wavelength. Therefore, only the light of λ can be observed by an observer (not shown) standing in the direction of the angle β, and hence, the color becomes considerably different from the external light.

On the other hand, in the case of the light control device having a scattering screen in this embodiment, as shown in (b), since the light enlarged in the specific angle range by the scattering screen 101 enters into the hologram 102, the observer standing in the direction of the angle β can also observe the colors of light of the wavelength λ1 and λ2.

As the reason for that, the following can be considered. The scattering function of the scattering screen has generally less wavelength dependence. Therefore, the scattering screen scatters and outputs the light of the wavelength λ, λ1 and λ2 together in the range of about ± △θ. Accordingly, if it is β-β1 < △θ, and β2-β < △θ, the light of the wavelength λ, λ1 and λ2 is directed towards the observer, seen from the direction of angle β. Hence, the output light becomes close to the color of the original external light Q.

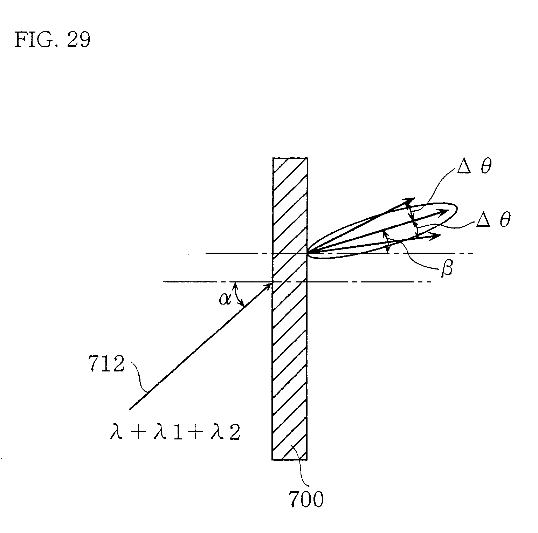

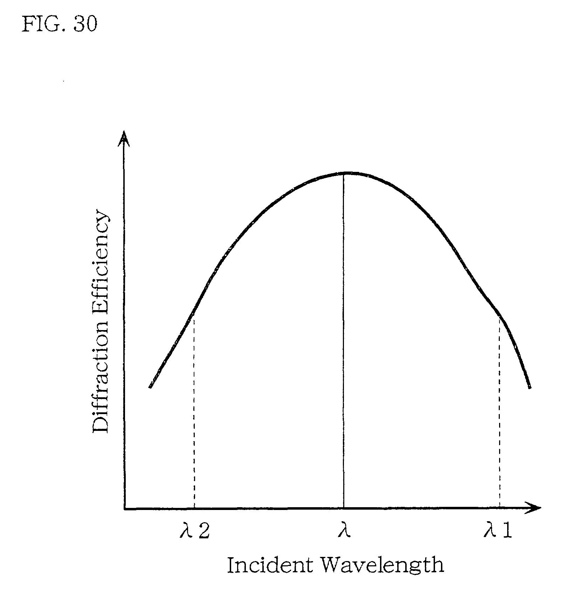

Next is a case where a scattered light is used as the object light of the conventional hologram. This has also a problem. This problem will be described using Fig. 29. The hologram 700 is prepared by using a preparation wavelength λ, the incident angle α of the reference light, and the object light being a scattered light having an incident angle β±θ. In this case, as with the light control device in this embodiment shown in Fig. 28, it is possible to observe the light of the wavelength λ1 and λ2 from the direction of the angle β. However, the diffraction efficiency of the light of the wavelength λ1 and λ2 in this case becomes low compared to the wavelength λ. Hence, compared to a case where only the hologram is used, the light is closer to the color of the external light, but there is still a limitation. That is to say, when the wavelength λ1 and λ2 incident at the same angle α are diffracted to the angle β due to the scattering action of the hologram, the hologram generally has a wavelength dependence of diffraction efficiency, as shown in Fig. 30, and hence the efficiency becomes low.

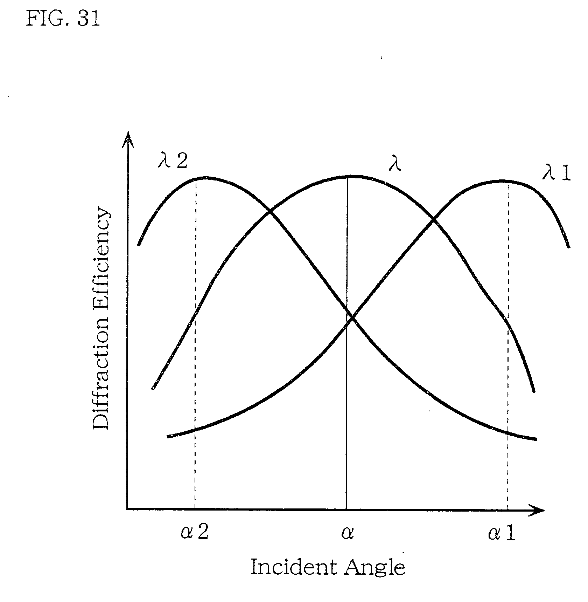

As shown in Fig. 28(a), the light of the wavelength λ1 incident on the hologram at the angle α is strongly deflected and output at an angle β1 (<β). Therefore, what is deflected in the direction of the angle β in the light of the wavelength λ1 is a component wave incident at the angle α1 larger than the angle α. With the light control device in this embodiment, a part of the light of the wavelength λ1 incident at the angle α enters into the hologram at an angle α1 (>α) by the scattering screen. At this time, as shown in Fig. 31, the diffraction efficiency is increased than that when entering at the angle α, as the property of the hologram.

In the case of the wavelength λ2 (<λ), the light is output at an angle β2 (>β). Accordingly, what is deflected in the direction of the angle β is a component incident at the angle α2 smaller than the angle α. With the angle dependence with respect to the wavelength λ2, as shown in Fig. 31, the diffraction efficiency increases, in the case of a small incident angle, on the contrary to the case of the wavelength λ1. In this manner, in the case of the light control device of the present invention, in both cases of the longer wavelength λ1 and shorter wavelength λ2 than the production wavelength λ, the incident angle having high diffraction efficiency is deflected to the direction of the angle β.

Accordingly, the color reproduction becomes more excellent than the conventional hologram which deflects each wavelength to the angle β with a single hologram having the scattering function. That is to say, according to the light control device in this embodiment, the light of different wavelength can be diffracted and deflected in the same direction at substantially the same efficiency.

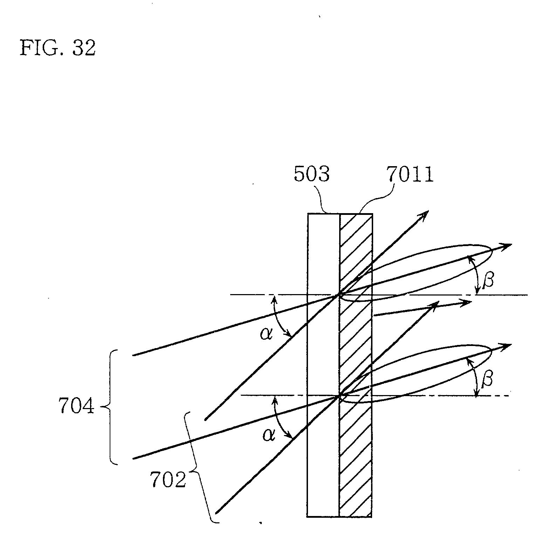

Next, a case where the object light is a scattered light, that is, the preparation method of the hologram shown in Fig. 29 will be described with reference to Fig. 32.

A hologram recording material 7011 and a scattering screen 503 are stuck and arranged together. The reference light 702 is a substantially parallel light incident at an angle α. The object light 704 is a substantially parallel light incident at an angle β. At this time, the incident angle α of the reference light is outside the scattering angle range of the scattering screen 503, and at the same time, the incident angle of the object light is within the scattering angle. As a result; while the reference light is transmitted through the scattering screen without being scattered, the object light is scattered by the scattering screen, and transmitted by being scattered, for example, to the angle of β ± △β. The interference fringes by means of these two beams are recorded on a hologram recording material, to thereby prepare the hologram.

### (Embodiment 2-6)

This embodiment relates to an image display device using a light control device of the embodiment 2-5.

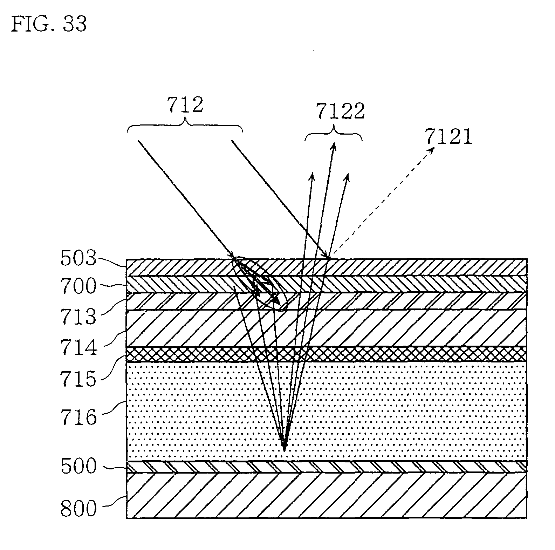

Fig. 33 shows a section of a reflective image display device (display element) using a liquid crystal in this embodiment. A light control device 1 according to the present invention described in the above embodiment is arranged in intimate contact with the reflective image display device. In this embodiment, an example where the scattering screen 503 and the hologram 700 described in the former embodiment are combined will be described.

An external light 712 for reading the image enters substantially at an angle α, and then enters into the scattering screen, except of a surface reflected component 7121 directed toward about an angle -α. The scattering angle range that the scattering screen scatters the incident light is α ± △α, hence the external light is scattered and enlarged in the range of an angle α ± △θ, and enters into the hologram, being an optical deflection means.

The hologram deflects the incident light to substantially β ± △θ by means of diffraction function, and outputs as the input light of the reflective image display device 2. The reflective image display device may be any device so long as it modulates and reflects the external light to thereby display the image, and for example, in this embodiment, a normal reflective liquid crystal display device is used. The external light input to the reflective liquid crystal device passes through a polarizing plate 713, a glass and ITO 714, for example, a color filter 715, and a liquid crystal layer 716, and reflected by a mirror 500 disposed on the substrate 800 on the background side. Moreover, the external light again passes through the liquid crystal layer, color filter, glass and ITO, and polarizing plate, to become an output light 7121 for displaying the image.

At this time, the output light is substantially distributed in the range of angle -β ± △θ. The hologram has sufficiently low diffraction efficiency with respect to the incident light of the incident angle of -β ± △ θ, hence the light is not diffracted, and transmitted directly. Moreover, by designating the angle -β ± △θ as being outside the scattering angle range, the light is directly transmitted through the scattering screen. Therefore, the image can be observed substantially in a range of the angle -β ± Δθ.

That is to say, the surface reflected component light and the output light observed as the image are clearly separated. Hence, compared to an image display device where only a hologram having the conventional scattering function is provided, an excellent image having a high contrast and high visual recognition observability can be displayed. This is because color reproduction is considerably improved by adding a scattering function to the scattering screen separately provided. The range where an image having excellent color reproduction can be visually recognized may be further enlarged, by giving a scattering function to the optical deflection means (hologram in this embodiment).

The scattering screen used here has preferably scattering anisotropy. That is to say, while the incident light in the vicinity of the angle at which the external light enters is scattered, it is desirable that the light output from the reflective image display device is transmitted. Because, if the output image of the reflective image display device is scattered, the image becomes unclear, decreasing the visual recognition observability.

Moreover, the reflective liquid crystal display device in this embodiment does not depend on the operation mode of the liquid crystal and color display method. A monochromatic display reflective liquid crystal device may be used. Also, the mirror in the reflective liquid crystal display device may be a mirror having a scattering property even on the mirror face.

Other than the reflective liquid crystal display device, optical deflection type image display device disclosed in, for example, U.S. Patent No. 5,096,279 may be used.

Moreover, it is not always necessary that the scattering screen and the optical deflection means have the same size and shape as those of the display image of the reflective image display device. For example, the construction may be such that the external shape of the scattering screen is made to be a heart, and only an image cut out by the heart is deflected. Then, if the image is observed from the direction of angle -β, a bright image having a heartshaped external shape (profile) is displayed. This applies also to the optical deflection means. Small pieces in the same shape may be also arranged in a plurality of numbers to thereby form a scattering screen or optical deflection means. This applies to respective diffractive optics in other embodiments.

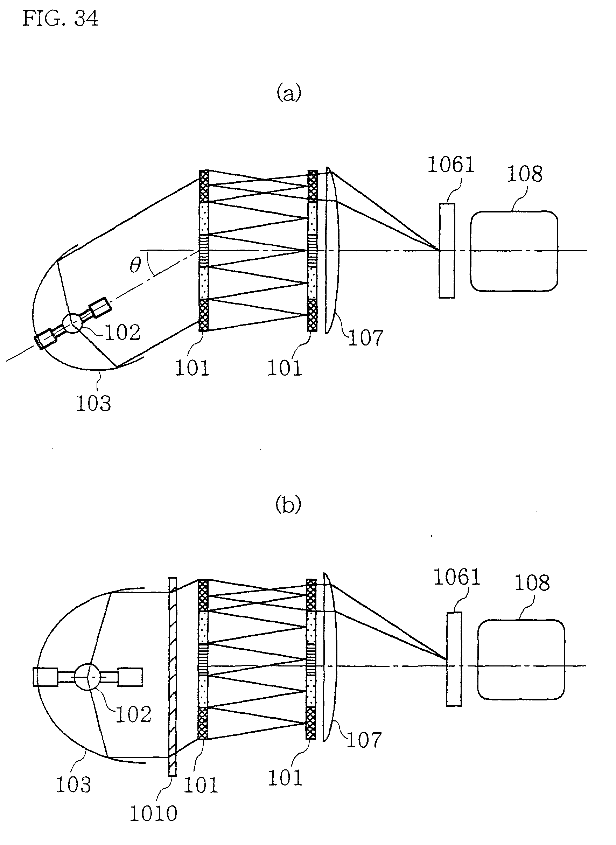

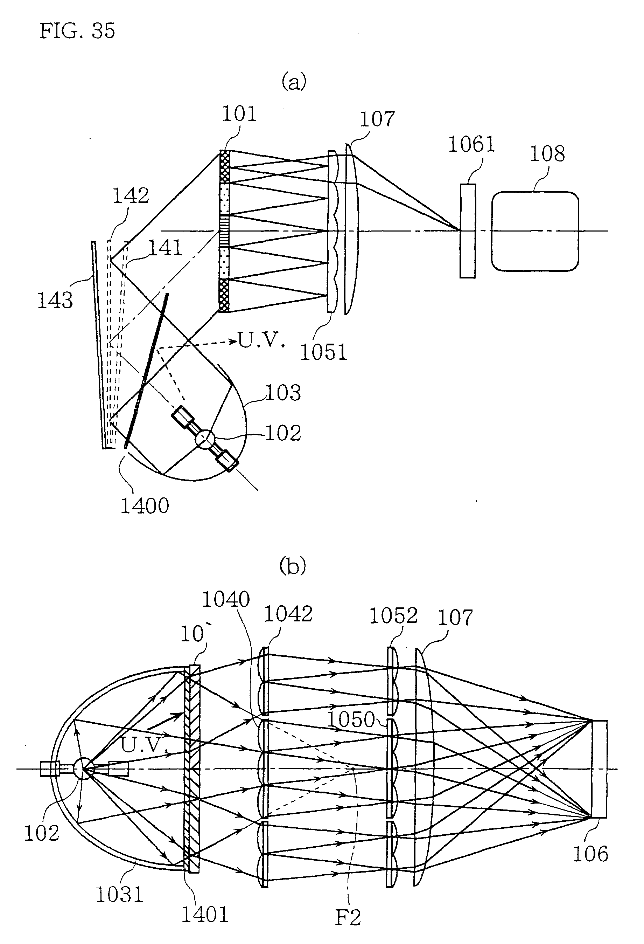

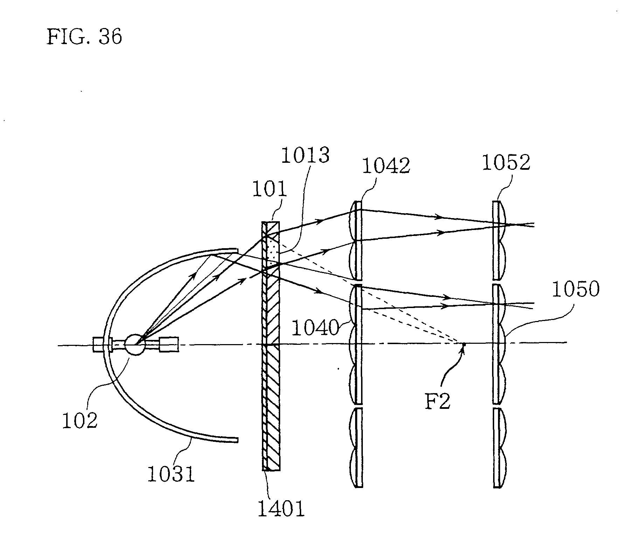

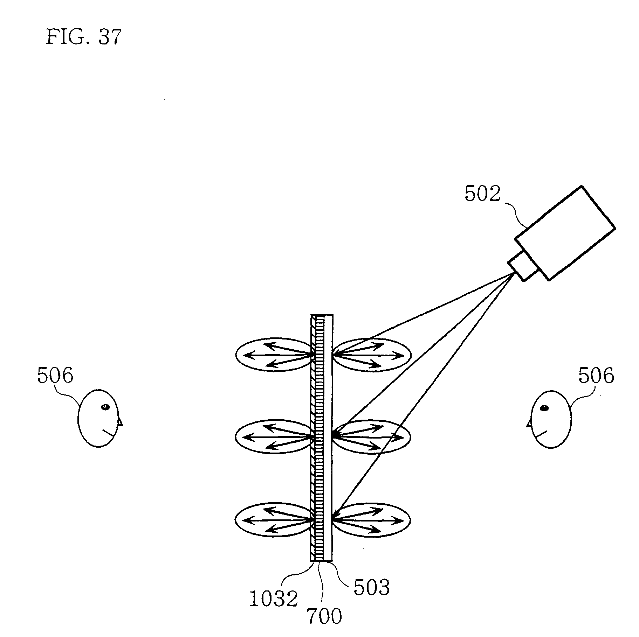

The present invention has been described based on several embodiments, but needless to say, the present invention is not limited to these embodiments. That is to say, the present invention may have a construction described below.
1) In the first invention group, since an object to be illuminated is a liquid crystal display device, the lens arrays on the downstream side shown in Fig. 9 and Fig. 13 may be also replaced by the diffractive optics. As a result, a projection device can be obtained at a lower cost. These are shown in Fig. 34 (a) and (b).
2) The light source is one including considerable ultraviolet rays, such as a high-pressure mercury-vapor lamp, and hence if there is a possibility that the ultraviolet rays have any adverse effect on the observer, or decompose the object to be illuminated or shorten the life thereof, a mirror 1400 may be disposed for first reflecting and excluding the ultraviolet rays as a dichroic mirror in the most upstream side in Fig. 11. This is shown in Fig. 35 (a). Fig. 35 (b) shows a case where a glass 140 is disposed for absorbing ultraviolet rays on the front face on the light source side of the diffractive optics of a lighting device shown in Fig. 5.
3) In order to cool the light source, a gap is provided between the mirror opening end and a light-condensing diffractive element (and a glass plate to which the light-condensing diffractive element is adhered). This is shown in Fig. 36.
4) As a dichroic mirror shown in Fig. 11, there is used a substance having a cholesteric structure (liquid crystal or the like) that reflects only a light having a wavelength corresponding to a helix pitch and transmits other lights.
5) In the second invention group, a half mirror (half reflection means) 1032 is disposed on the downstream side (opposite to the light source side) of a thin film comprising a scattering screen having an incident angle dependency due to scattering and a holographic or the like shown in Fig. 19. Thereby, the image can be seen from both sides of the thin film (for example, from inside and outside a room). Fig. 37 shows this. In this case, it is also possible to use this structure in such a manner that an image for publicity and advertisement is displayed on a screen serving also as a part (basically the upper part or an eye's position) of a partition for separating a passage depending on the running direction, and the passage (a part of it) is illuminated by the image light.
   At this time, the ratio of the reflected light of the half mirror and transmitted light is not necessarily be 1:1, and needless to say, adjusting means may be added in the reflection section so that the light quantity illuminated toward the darker side decreases.
6) The thin film supporting the diffractive optics and the scattering screen is not a glass such as show windows or normal windows, but a plastic, a wall or a metal thin film. When it is a wall or a metal thin film, a mirror is used together.
7) The shape of the image, the diffractive optics, scattering screen or the like is not square such as a normal screen, but is circular or heartshaped. In this case, as is understood from the above description, even if the shape is complicated, they can be easily produced.
   Similarly, the shape thereof is not always plane, but may be cylindrical, spherical, or the like depending on the shape of a face to be projected.
   It is also possible to form ones having an optional large size by adhering a plurality of small elements, in particular, replicas. Thereby, wide screens or screens having a complicated three dimensional shape can be produced at a low cost.
8) Depending on properties of the projected image and requirements such as visibility required therefor, trapezoidal correction is performed to form a clearer projected image.
9) In order to increase the light utilization efficiency as much as possible, a reflection protection film is formed according to the color on a thin film of each constituent, or these are bonded in vacuum in order to prevent the air from coming into the inside of these films. Also, a material is chosen such that the dielectric constant of the glass plate or plastic plate serving as an adhesive or a support becomes the same as that of the diffractive optics as much as possible.

### Industrial Applicability

As is understood from the above description, in the present invention, the lighting device used for projecting images, semiconductor production or the like can be produced at a low cost, and in a small size and light weight.

Similarly, the efficiency of the lighting device is increased.

Also, a long life can be achieved.

Moreover, uniformity in the energy density and brightness of the projected plane and screen can be obtained.

There can be obtained an excellent image projection device in view of color reproduction, discrimination of light and shade, arrangement of each devices, the size of the visual image and angle of visibility, in particular, when it is used as a liquid crystal display device, or a projection device of an image on a show window or a passage in a underground shopping center.

Moreover, when it is used for displaying an image on a wall in combination with a mirror or a half mirror, similar effects can be obtained.

When being used in a display section of a liquid crystal display device utilizing an external light, it can be a display device easy to see with a large shading ratio.

When it is used for a show window or the like, since the image is large and clear, it easily calls customer's attention, to thereby increase publicity and advertising effects.

In view of the convenience of production of the lighting device according to the present invention, the diffractive optics itself is produced more easily compared to the fly eye lens or the like, and it is also possible to form a plurality of small lenses to form a large lens, and hence further cost reduction can be achieved.

Thinking of these effects, the industrial applicability of the present invention is considerably large.

In particular, when the first invention group and the second invention group are integrally executed, its effects and applicability becomes considerably large.

## Claims

1. A lighting device comprising:
a light source;
a diffractive optics in which a plurality of small areas are arranged two dimensionally in order to evenly condense a bundle of light from said light source onto an object to be illuminated; and
a lens arrayin which a plurality of small lenses corresponding to said plurality of small areas are arranged two dimensionally in order to evenly condense a bundle of light transmitted through said diffractive optics onto the object to be illuminated.

2. A lighting device according to claim 1, further comprising:
polarization separation means located on the downstream side of said diffractive optics for letting a polarization component passing through the polarization transmission means on the further downstream side transmit directly, and separating a polarization component which does not pass through the polarization transmission means; and
means of rotating the plane of polarization which rotates the plane of polarization in the polarization separated by said polarization separation means to an angle corresponding to the polarization transmission means on the further downstream side to thereby be input in said lens array.

3. A lighting device according to claim 1 or 2, further comprising:
color separation means disposed on the upstream side of said diffractive optics, for separating the bundle of light output from the light source into a bundle light of a plurality of colors, and making the bundle of light enter into said diffractive optics at an adequate angle determined by a wavelength for each separated bundle of light of each color.

4. A lighting device to claim 1, 2 or 3, wherein said color separation means is dichroic mirror type color separation means which combines a dichroic mirror for each color for selectively reflecting only one specific color of the separated bundle of light of a plurality of colors, while making it intersect at a predetermined angle different to each other with respect to the optical axis of the light source.

5. A lighting device according to claim 1 or 2, further comprising a diffractive optics for incident angle adjustment which diffracts the bundle of light output from said light source to an acute angle, so as to become an optimum incident angle with respect to said optical element.

6. A lighting device comprising a light source and a reflection mirror for reflecting the output light of said light source and condensing light, wherein
said lighting device further comprises diffraction means which is located at an opening of said reflection mirror, and directly transmits the light reflected by said reflected mirror of the output light of said light source, and diffracts a bundle of light output in the outward direction directly from the opening of said reflection mirror without being reflected, so as to irradiate an object to be illuminated, since such a bundle of light enters inclined from the right angle to the side opposite to the optical axis to some extent.

7. A lighting device according to claim 6, further comprising:
an integrator on the optical axis side consisting of a set of optical systems for adequately irradiating a first bundle of light reflected once by the reflection mirror and condensed with a predetermined angle onto an object to be illuminated; and
an integrator on the outer peripheral side consisting of a set of optical systems for adequately irradiating a second bundle of light diffracted and condensed by said diffraction means without being reflected by the reflection mirror onto the object to be illuminated.

8. A lighting device according to claim 7, wherein said reflection mirror is an ellipsoidal mirror, and said integrator on the optical axis side comprises:
an optical element in which a plurality of small areas are arranged two dimensionally in order to evenly [condense] a bundle of light from said light source onto an object to be illuminated; and
an optical element in which a plurality of small lenses corresponding to said plurality of small areas are arranged two dimensionally in order to evenly condense a bundle of light transmitted through said optical element onto the object to be illuminated.

9. A lighting device according to claim 7, wherein said integrator on the outer peripheral side comprises:
an optical element in which a plurality of small areas are arranged. two dimensionally in order to evenly condense a bundle of light from the optical system diffracted by said diffraction means onto an object to be illuminated; and
an optical element in which a plurality of small lenses corresponding to said plurality of small areas are arranged two dimensionally in order to evenly condense a bundle of light transmitted through said optical element onto the object to be illuminated.

10. A lighting device according to claim 7, 8 & 9, wherein said integrator on the optical axis side and said integrator on the outer peripheral side comprise:
polarization separation means for letting a polarization component passing through the polarization transmission means located on the downstream side of the lighting device transmit directly, and separating the polarization component which does not pass through the polarization transmission means; and
means of rotating the plane of polarization which rotates the polarization component separated by said polarization separation means to an angle corresponding to said polarization transmission means on the downstream side.

11. A lighting device according to claim 7, 8, 9 or 10, wherein said integrator on the optical axis side and said integrator on the outer peripheral side are inside and outside superimposed type integrators in which the light condensed in said plurality of small areas is substantially superimposed on the same object to be illuminated.

12. A lighting device according to any of claims 6 to 11, wherein said diffraction means is hologram type diffraction means comprising a hologram.

13. A lighting device according to any of claims 7 to 12, wherein at least one of the optical element of the integrators on said central side and on the outer peripheral side uses a holographic lens.

14. An image display device comprising:
a scattering screen having scattering anisotropy which scatters a bundle of light incident from inside of a predetermined angle range and transmits a bundle of light incident from outside of said predetermined angle range without substantially scattering it;
projection type image display means which substantially images a projection image on said scattering screen, wherein the incident angle of the image projected on said scattering screen is substantially within said predetermined incident angle range; and
optical deflection means such as Fresnel lens disposed on the surface side opposite to the incident light side of said scattering screen, whose focal point is in the vicinity of said projection type image display means, and which bends the incident light scattered by the scattering screen to a predetermined direction.

15. An image display device according to claim 14, wherein said Fresnel lens as the optical deflection means is an enlarged display Fresnel lens which is arranged so that the distance between said scattering screen and said Fresnel lens is less than the focal length of the Fresnel lens to thereby display the image on the scattering screen in an enlarged scale.

16. An image display device comprising:
a scattering screen having such scattering anisotropy that scatters a bundle of light incident from inside of a predetermined angle range and transmits a bundle of light incident from outside of said predetermined angle range without substantially scattering it, and having an optical deflection means such as a hologram disposed therein which bends the incident light scattered on the surface side in the rearward direction to a predetermined direction; and
projection type image display means which substantially images a projection image on said scattering screen, wherein the incident angle of the image projected on said scattering screen is substantially within said predetermined incident angle range.

17. An image display device according to claim 16, wherein said hologram is an angle consideration type hologram produced such that the reference light incident angle at the time of production of said hologram is substantially equal to the incident angle of said projection type image display means, and the object light incident angle distribution substantially coincides with the image display range.

18. An image display device according to claim 16 or 17, wherein said scattering screen is an incident light angle adjusting type scattering screen in which the incident angle scattering the incident light is substantially equal to the reference light incident angle of said hologram.

19. A production method of a hologram used for an image display device comprising a scattering screen having such scattering anisotropy that scatters a bundle of light incident from inside of a predetermined angle range and transmits a bundle of light incident from outside of said predetermined angle range without substantially scattering it, and having an optical deflection means using a hologram disposed therein which bends the incident light scattered on the surface side in the rearward direction to a predetermined direction; and projection type image display means which substantially images a projection image on said scattering screen, wherein the incident angle of the ima'ge projected on said scattering screen is substantially within said predetermined incident angle range; or a hologram used for an image display device wherein said hologram is produced such that the reference light incident angle at the time of production of said hologram is substantially equal to the incident angle of said projection type image display means, and the distribution of the object light incident angle substantially coincides with the image display range, which comprises:
an arrangement step for arranging the scattering screen on the laser light incident side of a hologram recording material, in order to form said scattering screen made of a hologram which does not have a scattering function with respect to the direction of the incident angle of said reference light; and
an incident step for letting an object light enter from a direction that said scattering screen scatters light.

20. A production method of a hologram used for an image display device comprising a scattering screen having such scattering anisotropy that scatters a bundle of light incident from inside of a predetermined angle range and transmits a bundle of light incident from outside of said predetermined angle range without substantially scattering it, and having an optical deflection means such as a hologram disposed therein which bends the incident light scattered on the surface side in the rearward direction to a predetermined direction; and projection type image display means which substantially images a projection image on said scattering screen, wherein the incident angle of the image projected on said scattering screen is substantially within said predetermined incident angle range; said scattering screen being an incident light angle adjusting type scattering screen in which the incident angle scattering the incident light is substantially equal to the reference light incident angle of said hologram, which comprises:
an arrangement step for arranging the scattering screen on the laser light incident side of a hologram recording material, in order to form said scattering screen made of a hologram which does not have a scattering function with respect to the direction of the incident angle of said reference light; and
an incident step for letting an object light enter from a direction that said scattering screen scatters light.

21. A hologram production method according to claim 19 or claim 20 comprising a scattering screen selection step for selecting, as said arranged scattering screen, a vertical incident light selecting scattering screen having a function for selectively scattering substantially only the vertical incident beam of light.

22. A hologram production method according to claim 19, 20 or 21 comprising an object light angle selection step for selecting converging rays or diverging rays, as the object light.

23. An image display device comprising:
projection type image display means;
a scattering screen located on the downstream side of said projection type image display means, on which the output image light from said projection type image display means is projected; and
deflection means disposed ahead on the downstream side of said scattering screen, for directing the scattered light from said scattering screen to a predetermined direction.

24. An image display device according to claim 23 wherein said deflection means is a Fresnel lens.

25. An image display device according to claim 23, wherein said deflection means is a hologram.

26. An image display device having a scattering screen, a reflection member and projection type image display means, wherein
said scattering screen is an anisotropic scattering screen having scattering anisotropy, which scatters a bundle of light incident from inside of a predetermined angle range and transmits a bundle of light incident from outside of said predetermined angle range without substantially scattering it;
said reflection member is a rear reflection member located on the back of the scattering screen in order to reflect an image light transmitted from said projection type image display means and transmitted through said scattering screen, or scattered and transmitted therethrough; and
said projection type image display means is a projection type image display means of a type arranging projection image light to be scattered in which at least one of the incident angle of an image light imaged and projected in the vicinity of said scattering screen or the incident light of the image light transmitted through said scattering screen and reflected by said reflection member and again incident from the back face onto the scattering screen is positioned within a predetermined angle range for scattering said incident angle.

27. An image display device according to claim 26, wherein said image display device has optical deflection means which does not scatter but transmits the projected light from said projection type image display means onto the surface on the front side of the scattering screen, but refracts the light incident from the scattering screen side on the background in a predetermined direction.

28. An image display device according to claim 27, wherein said optical deflection means is diffracted light deflection means using a diffractive optics.

29. An image display device according to claim 28, wherein said diffractive optics is a hologram type optical element using a hologram.

30. An image display device according to claim 29, wherein said hologram is produced by coherent two-beam interference exposure.

31. An image display device according to claim 29 or 30 wherein said hologram is an incident angle adjusting type hologram in which the reference light incident angle at the time of production thereof is made to be substantially equal to an angle of a projection image of said projection type image display means incident onto said hologram after being reflected by said reflection member.

32. An image display device according to claim 29 or 30 wherein said hologram is an incident angle adjusting type hologram in which the reference light incident angle at the time of production thereof is made to be within a predetermined incident angle range, at which said scattering screen scatters the incident light.

33. A production method of a hologram for an image display device comprising: a scattering screen having scattering anisotropy, which scatters a bundle of light incident from inside of a predetermined angle range and transmits a bundle of light incident from outside of said predetermined angle range without substantially scattering it; a reflection member located on the side opposite to the incident light side on the scattering screen in order to reflect an image light transmitted through said scattering screen, or scattered and transmitted therethrough; and a projection type image display means in which at least one of the incident angle of an image light imaged and projected in the vicinity of said scattering screen or the incident light of an image light transmitted through said scattering screen and reflected by said reflection member and again incident from the back face onto the scattering screen is positioned within a predetermined angle range for scattering said incident angle, said image display device having optical deflection means which does not scatter but transmits the projected light from said projection type image display means onto the surface on the front side of the scattering screen, but refracts the light incident from the scattering screen side on the background in a predetermined direction, said optical deflection means being produced by coherent two-beam interference exposure, and said image display device using a hologram in which the reference light incident angle at the time of production thereof is made to be substantially equal to an angle of a projection image of said projection type image display means incident onto said hologram after being reflected by said reflection member, or to be within a predetermined incident angle range, at which said scattering screen scatters the incident light, wherein said hologram production method comprises:
a scattering screen arrangement step for arranging a scattering screen having scattering anisotropy, which scatters a bundle of light incident from inside of a predetermined incident angle range and substantially transmits a bundle of light incident from outside of said predetermined incident angle range, on a laser light incident plane of said hologram recording material;
a light incidence step for letting an object light enter from inside of said predetermined incident angle range, and letting the reference light enter from outside of said predetermined incident angle range; and
a recording step for recording interference fringes formed by said light incidence step on a hologram recording material.

34. A hologram production method according to claim 33, wherein said light incidence step is an incident angle adjusting incidence step in which the incident angle of the reference light is substantially equal to the incident angle at which said projection type image display means inputs an image on said scattering screen.

35. A hologram production method according to claim 33 or 34, wherein said light incidence step is an object light incident angle adjusting incidence step in which the incident angle of an object light is outside said predetermined incident angle range of said arranged scattering screen.

36. A hologram production method according to claim 33, 34 or 35, wherein said light incidence step is a reference light incident angle adjusting step in which the incident angle of the reference light is made to be substantially equal to the incident angle at which an image is input on the scattering screen after the projection image of said projection type image display means is reflected by the reflection member.

37. A hologram production method according to claim 33, 34, 35 or 36 wherein said scattering screen arrangement step has a function for selectively scattering only substantially vertical incident rays, as the arranged scattering screen.

38. A light control device comprising;
a scattering screen having scattering anisotropy, which scatters a bundle of light incident from inside of a predetermined angle range and transmits a bundle of light incident from outside of said predetermined angle range without substantially scattering it; and
optical deflection means disposed on the side opposite to the incident light side of said scattering screen, which transmits the scattered light and transmitted light by refracting these by a predetermined angle.

39. Alight control device for image display having a scattering screen, optical deflection means and reflection means, wherein
said scattering screen has scattering anisotropy, which scatters a bundle of light incident from inside of a predetermined angle range and transmits a bundle of light incident from outside of said predetermined angle range without substantially scattering it;
said optical deflection means is disposed on the side opposite to the incident light side of said scattering screen, for transmitting a bundle of light having passed through the scattering screen and reflected light from said reflection means by deflecting these by a predetermined angle; and
said reflection means is disposed on the side opposite to the incident light side of said optical deflection means, for reflecting light having passed through said optical deflection means.

40. A light control device according to claim 38 or 39, wherein said optical deflection means is diffraction deflection means using a diffractive optics.

41. A light control device according to claim 40, wherein said diffractive optics is a hologram type diffractive optics using a hologram.

42. A light control device according to claim 41, wherein said hologram is a hologram considering incident angle to be referenced, in which the reference light incident angle at the time of production thereof is made to be within a predetermined incident angle range of said scattering screen having the scattering anisotropy.

43. A light control device according to claim 41 or 42, wherein said hologram is a hologram utilizing diffraction, which diffracts and deflects light scattered by said scattering screen having the scattering anisotropy, and outputs the light.

44. A light control device according to claim 41, 42 or 43, wherein the object light at the time of preparing the hologram as said diffractive optics is either one of the substantially parallel light, converging rays, diverging rays or scattered light.

45. A light control device according to any of claims 41 to 44, wherein the hologram as said diffractive optics is a hologram considering incident angle after reflection, such that the angle of the incident light deflected by the hologram incident onto the scattering screen after being reflected by the reflection means disposed on the back face becomes outside the predetermined angle range of said scattering screen. predetermined angle range of said scattering screen.

46. A reflective type liquid crystal display device having, as the element in the display section, a light control device for image display comprising a scattering screen, optical deflection means and reflection means, wherein
said scattering screen is a scattering anisotropic scattering screen which scatters a bundle of light incident from inside of a predetermined angle range and transmits a bundle of light incident from outside of said predetermined angle range without substantially scattering it;
said optical deflection means is disposed on the reflected incident light side of said scattering screen, for transmitting a bundle of light having passed through the scattering screen and reflected light from said reflection means by refracting these by a predetermined angle; and
said reflection means is disposed on the side opposite to the incident light side of said optical deflection means, for reflecting light having passed through said optical deflection means.

47. A reflective type liquid crystal display device according to claim 46 wherein said optical deflection means is diffraction deflection means using a diffractive optics.

48. A reflective type liquid crystal display device according to claim 47 wherein said diffractive optics is a hologram type diffractive optics using a hologram.

49. A light control device for image display comprising a scattering screen, optical deflection means and half reflection means, wherein
said scattering screen has scattering anisotropic scatter, which scatters a bundle of light incident from inside of a predetermined angle range and transmits a bundle of light incident from outside of said predetermined angle range without substantially scattering it;
said optical deflection means is disposed on the side opposite to the incident light side of said scattering screen, for transmitting a bundle of light having passed through the scattering screen and reflected light from said half reflection means by deflecting these by a predetermined angle; and
said half reflection means is disposed on the side opposite to the incident light side of said optical deflection means, for directly transmitting a part of lights and reflecting the other part of lights having passed through said optical deflection means.

50. A light control device according to claim 49, wherein said optical deflection means is diffraction deflection means using a diffractive optics.

51. A light control device according to claim 50, wherein said diffractive optics is a hologram type diffractive optics using a hologram.
